# EUROPEAN PATENT APPLICATION

(11) **EP 4 804 170 A1**
(43) Date of publication of application: **09.09.2026**
(21) Application number: 26160960.6
(22) Date of filing: 26.02.2026
(51) Int. Cl.: G09G 3/3208, H10K 59/35, H10K 59/121

(54) **DISPLAY DEVICE AND ELECTRONIC APPARATUS INCLUDING THE SAME**

(30) Priority: 04.03.2025 KR 20250027431; 10.07.2025 KR 20250092889
(71) Applicant: Samsung Display Co., Ltd., Yongin-si, Gyeonggi-do 17113 (KR)
(72) Inventor: PARK, Do Yeong, Giheung-gu, Yongin-si, Gyeonggi-do (KR); SHIN, Dong Hee, Giheung-gu, Yongin-si, Gyeonggi-do (KR); KIM, Yun Mi, Giheung-gu, Yongin-si, Gyeonggi-do (KR); KIM, Hyeong Seok, Giheung-gu, Yongin-si, Gyeonggi-do (KR)
(74) Representative: Dr. Weitzel & Partner

(57) **Abstract**

A display device includes a display panel. The display panel includes a display area in which emission areas are arranged, a circuit layer, and light emitting elements disposed in the emission areas on the circuit layer. The emission areas are arranged in a first direction and a second direction. The circuit layer includes light-emitting pixel drivers arranged side by side in the first direction in the display area and electrically connected to the light emitting elements. Eight of the light emitting elements, disposed in eight of the emission areas neighboring each other in the first direction, the second direction and a diagonal direction intersecting the first direction and the second direction are electrically connected to eight of the light-emitting pixel drivers arranged side by side in the first direction.

## Description

The present invention is directed to a display device and an electronic apparatus including the same.

With the growth of the information society, demand for display devices capable of presenting images continues to increase. Such display devices may be used in a wide variety of electronic apparatuses, including smartphones, digital cameras, notebook computers, navigation devices, and smart televisions.

The display devices may be flat panel display devices such as liquid crystal displays, field emission displays, or light emitting displays. The light emitting displays may include an organic light emitting display having an organic light emitting element, an inorganic light emitting display having an inorganic light emitting element such as an inorganic semiconductor, or a micro- or nano-light emitting display having a micro- or nano-light emitting element.

An organic light emitting display device may display an image using light emitting elements, each including a light emitting layer formed of an organic light emitting material. Such a display device, which employs self-light emitting elements, may exhibit relatively superior performance in terms of power consumption, response speed, luminous efficiency, luminance, and viewing angle.

A display surface of the display device may be divided into emission areas in which light emitting elements are formed. As display resolution increases, arranging the emission areas together with their corresponding pixel drivers within limited panel space becomes more difficult, since additional wiring lines are required to supply power, control, and data signals. The resulting increase in wiring density may lead to larger driver circuits, reduced layout efficiency, and limits on achievable resolution.

A display device may include light-emitting pixel drivers that transmit driving currents to light emitting elements. Reducing the width of the light-emitting pixel drivers allows more of the light-emitting pixels drivers to be arranged in the display area, thereby enabling the display device to have a higher resolution. Accordingly, at least one embodiment of the present invention provides a display device, and an electronic device including the display device, that can achieve higher resolution through a configuration that enables the width of the light-emitting pixel drivers to be reduced.

The invention is defined by the features of independent claim 1. The dependent claims and the description provide preferred embodiments.

According to an embodiment of the present invention, there is provided a display device that includes a display panel. The display panel includes a display area in which emission areas are arranged, a circuit layer, and light emitting elements disposed in the emission areas on the circuit layer. The emission areas are arranged in a first direction and a second direction (e.g., in horizontal and vertical directions). The circuit layer includes light-emitting pixel drivers arranged side by side in the first direction, for example in a row along the first direction, in the display area and electrically connected to the light emitting elements. A group of the light emitting elements, for example eight of the light emitting elements, disposed in a corresponding one of the emission areas, for example in eight of the emission areas, neighboring each other (or arranged) in the first direction, the second direction and a diagonal direction intersecting the first direction and the second direction among the emission areas are electrically connected to a corresponding one of the corresponding light-emitting pixel drivers arranged side by side with each other in the first direction, for example in the row along the first direction. Specifically, the eight of the light emitting elements, disposed in eight of the emission areas neighboring each other in the first direction, the second direction and the diagonal direction intersecting the first direction and the second direction may be electrically connected to eight of the light-emitting pixel drivers arranged side by side in the first direction.

According to the invention, the light-emitting pixel drivers, especially the first light-emitting pixel driver, the second light-emitting pixel driver, the third light-emitting pixel driver, the fourth light-emitting pixel driver, the fifth light-emitting pixel driver, the sixth light-emitting pixel driver, the seventh light-emitting pixel driver, and the eighth light-emitting pixel driver may be arranged only in the first direction, but not in the second direction. For example, although the emission areas, especially the first to eighth emission areas, are arranged in both directions, their light-emitting pixel drivers are arranged in a single row in the first direction.

The circuit layer may further include a first power line configured to transmit a first power voltage and a power connection transistor electrically connected between two of the light-emitting pixel drivers neighboring each other in the first direction and the first power line. Each of the light-emitting pixel drivers may further include a first transistor electrically connected between the power connection transistor and a first node and generating a driving current, where a first electrode of the first transistor may be electrically connected to the power connection transistor, and the first node may be electrically connected to a second electrode of the first transistor.

The circuit layer may further include a first semiconductor layer disposed on the substrate; a first interlayer insulating layer disposed on the first semiconductor layer; and a second semiconductor layer disposed on the first interlayer insulating layer and having an oxide semiconductor material. A channel, the first electrode and the second electrode of the first transistor may be disposed in the second semiconductor layer, and a channel, a first electrode and a second electrode of the power connection transistor may be disposed in the first semiconductor layer.

The eight emission areas may include a first emission area, a second emission area neighboring the first emission area in the diagonal direction, a third emission area neighboring the first emission area in the first direction, a fourth emission area neighboring the third emission area in the diagonal direction and neighboring the second emission area in the first direction, a fifth emission area neighboring the first emission area in the second direction, a sixth emission area neighboring the fifth emission area in the diagonal direction and neighboring the second emission area in the second direction, a seventh emission area neighboring the fifth emission area in the first direction and neighboring the third emission area in the second direction and an eighth emission area neighboring the seventh emission area in the diagonal direction, neighboring the sixth emission area in the first direction and neighboring the fourth emission area in the second direction.

The eight light-emitting pixel drivers may include a first light-emitting pixel driver electrically connected to a light emitting element of the first emission area, a second light-emitting pixel driver electrically connected to a light emitting element of the second emission area, a third light-emitting pixel driver electrically connected to a light emitting element of the third emission area, a fourth light-emitting pixel driver electrically connected to a light emitting element of the fourth emission area, a fifth light-emitting pixel driver electrically connected to a light emitting element of the fifth emission area, a sixth light-emitting pixel driver electrically connected to a light emitting element of the sixth emission area, a seventh light-emitting pixel driver electrically connected to a light emitting element of the seventh emission area and an eighth light-emitting pixel driver electrically connected to a light emitting element of the eighth emission area.

In an embodiment, each of the first emission area and the seventh emission area emits light of a first wavelength band, each of the second emission area, the fourth emission area, the sixth emission area and the eighth emission area emits light of a second wavelength band lower than the first wavelength band, and each of the third emission area and the fifth emission area emits light of a third wavelength band lower than the second wavelength band.

In an embodiment, the first electrode and a channel of the first transistor of the first light-emitting pixel driver are arranged symmetrically to the first electrode and the channel of the first transistor of the second light-emitting pixel driver with respect to a boundary between the first light-emitting pixel driver and the second light-emitting pixel driver, and the first electrode of the first transistor of the first light-emitting pixel driver is connected to the first electrode of the first transistor of the second light-emitting pixel driver.

In an embodiment, each of the light-emitting pixel drivers further includes a second transistor electrically connected between the first node and a second node; and a node connection electrode electrically connecting the second electrode of the first transistor and a first electrode of the second transistor. The second electrode of the first transistor of the second light-emitting pixel driver extends to one side in the second direction. The second electrode of the first transistor of the third light-emitting pixel driver extends to the other side in the second direction. The node connection electrode of the third light-emitting pixel driver extends in the second direction.

In an embodiment, each of the light-emitting pixel drivers further includes a second transistor electrically connected between a data line, which transmits a data signal, and a gate electrode of the first transistor; a third transistor electrically connected between a reference voltage line, which transmits a reference voltage, and the gate electrode of the first transistor; a fourth transistor electrically connected between an initialization voltage line, which transmits an initialization voltage, and a second node; a fifth transistor electrically connected between the first node and the second node; a first capacitor electrically connected between the gate electrode of the first transistor and the first node; and a second capacitor electrically connected between the first node and the first power line. In this embodiment, the second node is electrically connected to one of the light emitting elements.

In an embodiment, each of the first through eighth light-emitting pixel drivers intersect two scan write lines transmitting different scan write signals, one reset control line transmitting a reset control signal, one initialization control line transmitting an initialization control signal, one first emission control line transmitting a first emission control signal and one second emission control line transmitting a second emission control signal. In this embodiment, a gate electrode of the second transistor of each of the first through fourth light-emitting pixel drivers is electrically connected to one of the two scan write lines. In this embodiment, a gate electrode of the second transistor of each of the fifth through eighth light-emitting pixel drivers is electrically connected to the other of the two scan write lines. In this embodiment, a gate electrode of the third transistor of each of the first through eighth light-emitting pixel drivers is electrically connected to the one reset control line. In this embodiment, a gate electrode of the fourth transistor of each of the first through eighth light-emitting pixel drivers is electrically connected to the one initialization control line. In this embodiment, gate electrodes of four power connection transistors electrically connected to the first through eighth light-emitting pixel drivers are electrically connected to the one first emission control line. In this embodiment, a gate electrode of the fifth transistor of each of the first through eighth light-emitting pixel drivers is electrically connected to the one second emission control line.

In an embodiment, one of the first light-emitting pixel driver and the third light-emitting pixel driver intersects a first data line and is electrically connected to the first data line, the other of the first light-emitting pixel driver and the third light-emitting pixel driver is electrically connected to the first data line through a first data extension line extending in the first direction, one of the second light-emitting pixel driver and the fourth light-emitting pixel driver intersects a second data line and is electrically connected to the second data line, and the other of the second light-emitting pixel driver and the fourth light-emitting pixel driver is electrically connected to the second data line through a second data extension line extending in the first direction.

The circuit layer may further include constant voltage auxiliary lines extending in the second direction and transmitting constant voltages, and the first through eighth light-emitting pixel drivers intersect a first initialization voltage line extending in the first direction and transmitting a first initialization voltage and a second initialization voltage line extending in the first direction and transmitting a second initialization voltage different from the first initialization voltage. In this embodiment, the first initialization voltage line is electrically connected to first electrodes of the fourth transistors of some of the first through eighth light-emitting pixel drivers. In this embodiment, the second initialization voltage line is electrically connected to first electrodes of the fourth transistors of the remainder of the first through eighth light-emitting pixel drivers. In this embodiment, the constant voltage auxiliary lines includes a first power auxiliary line transmitting the first power voltage, a reference voltage auxiliary line transmitting the reference voltage, a first initialization voltage auxiliary line transmitting the first initialization voltage and a second initialization voltage auxiliary line transmitting the second initialization voltage. In this embodiment, the second electrode of the first transistor of each of the first through eighth light-emitting pixel drivers overlaps one of the constant voltage auxiliary lines in a third direction.

The circuit layer may further include data lines extending in the second direction and transmitting data signals; first auxiliary lines extending in the first direction; and second auxiliary lines extending in the second direction. In this embodiment, two neighboring data lines among the data lines intersect the first light-emitting pixel driver and the second light-emitting pixel driver, respectively, and two neighboring second auxiliary lines among the second auxiliary lines intersect the third light-emitting pixel driver and the fourth light-emitting pixel driver, respectively.

The display device may further include a display driving circuit supplying the data signals to the data lines, where the display panel further includes a non-display area disposed adjacent the display area. The circuit layer may further include data supply lines disposed in the non-display area and electrically connected between the data lines and the display driving circuit. In an embodiment, the display area further includes a bypass middle area, a first bypass side area disposed side by side with the bypass middle area in the first direction and contacting the non-display area and a second bypass side area disposed between the bypass middle area and the first bypass side area. The data supply lines may extend to the bypass middle area and the second bypass side area. The data lines may include a first data line disposed in the first bypass side area and a second data line disposed in the second bypass side area. The first auxiliary lines may include a first bypass auxiliary line electrically connected to the first data line. The second auxiliary lines may include a second bypass auxiliary line electrically connected to the first bypass auxiliary line and neighboring the second data line. A first data supply line transmitting a data signal of the first data line among the data supply lines may be electrically connected to the first data line through the first bypass auxiliary line and the second bypass auxiliary line. A second data supply line transmitting a data signal of the second data line among the data supply lines may be directly electrically connected to the second data line.

According to an embodiment of the present invention, there is provided an electronic device including a display device as described herein and configured to display an image; a memory configured to store an application; a processor configured to transmit an image data signal and an input control signal to the display device by executing the application; and a power module configured to supply power to the display device.

In an embodiment of the display device or the electronic device, the circuit layer further includes a first power line configured to transmit a first power voltage and a power connection transistor electrically connected between two of the light-emitting pixel drivers neighboring each other in the first direction among the light-emitting pixel drivers and the first power line, and each of the light-emitting pixel drivers includes a first transistor electrically connected between the power connection transistor and a first node and generating a driving current. In this embodiment, the first node is electrically connected to a second electrode of the first transistor, a first electrode of the power connection transistor is electrically connected to the first power line, a first electrode and a channel of the first transistor of a first one of the first light-emitting pixel drivers are arranged symmetrically to a first electrode and a channel of the first transistor of a second one of the light-emitting pixel drivers with respect to a boundary between the first one of the light-emitting pixel drivers and the second one of the light-emitting pixel drivers, and the first electrode of the first transistor of the first one of the light-emitting pixel drivers and the first electrode of the first transistor of the second one of the light-emitting pixel drivers are connected to each other and are electrically connected to a second electrode of the power connection transistor. The first one of the light-emitting pixel drivers may be the first light-emitting pixel driver and the second one of the light-emitting pixel drivers may be the second light-emitting pixel driver, and/or the first one of the light-emitting pixel drivers may be the third light-emitting pixel driver and the second one of the light-emitting pixel drivers may be the fourth light-emitting pixel driver, and/or the first one of the light-emitting pixel drivers may be the fifth light-emitting pixel driver and the second one of the light-emitting pixel drivers may be the sixth light-emitting pixel driver, and/or the first one of the light-emitting pixel drivers may be the seventh light-emitting pixel driver and the second one of the light-emitting pixel drivers may be the eighth light-emitting pixel driver, for example.

In an embodiment of the display device or the electronic device, each of the light-emitting pixel drivers further include a second transistor electrically connected between the first node and a second node; and a node connection electrode electrically connecting the second electrode of the first transistor and a first electrode of the second transistor. In this embodiment, the second electrode of the first transistor of the second light-emitting pixel driver extends to one side in the second direction. In this embodiment, the second electrode of the first transistor of a third one of the third light-emitting pixel drivers extends to the other side in the second direction and the node connection electrode of the third light-emitting pixel driver extends in the second direction.

In an embodiment of the display device or the electronic device, each of the light-emitting pixel drivers further includes a second transistor electrically connected between a data line, which transmits a data signal, and a gate electrode of the first transistor, a third transistor electrically connected between a reference voltage line, which transmits a reference voltage, and the gate electrode of the first transistor, a fourth transistor electrically connected between an initialization voltage line, which transmits an initialization voltage, and a second node, a fifth transistor electrically connected between the first node and the second node, a first capacitor electrically connected between the gate electrode of the first transistor and the first node and a second capacitor electrically connected between the first node and the first power line. In this embodiment, the first electrode of the first transistor is electrically connected to the power connection transistor, and the second node is electrically connected to one of the light emitting elements. In this embodiment, the circuit layer includes a first semiconductor layer, a first interlayer insulating layer disposed on the first semiconductor layer and a second semiconductor layer disposed on the first interlayer insulating layer and having an oxide semiconductor material. In this embodiment, the channel, the first electrode and the second electrode of the first transistor are disposed in the second semiconductor layer, and a channel, the first electrode and the second electrode of the power connection transistor are disposed in the first semiconductor layer.

In an embodiment of the display device or the electronic device, one of the first light-emitting pixel driver and a third one of the third light-emitting pixel drivers intersects a first data line and is electrically connected to the first data line, the other of the first light-emitting pixel driver and the third light-emitting pixel driver is electrically connected to the first data line through a first data extension line extending in the first direction, one of the second light-emitting pixel driver and a fourth one of the light-emitting pixel drivers intersects a second data line and is electrically connected to the second data line, and the other of the second light-emitting pixel driver and the fourth light-emitting pixel driver is electrically connected to the second data line through a second data extension line extending in the first direction.

In an embodiment of the display device or the electronic device, the eight light-emitting pixel drivers intersect two scan write lines transmitting different scan write signals, one reset control line transmitting a reset control signal, one initialization control line transmitting an initialization control signal, one first emission control line transmitting a first emission control signal and one second emission control line transmitting a second emission control signal. In this embodiment, a gate electrode of the second transistor of each of the first through fourth light-emitting pixel drivers is electrically connected to one of the two scan write lines. In this embodiment, a gate electrode of the second transistor of each of the fifth through eighth light-emitting pixel drivers is electrically connected to the other of the two scan write lines. In this embodiment, a gate electrode of the third transistor of each of the first through eighth light-emitting pixel drivers is electrically connected to the one reset control line. In this embodiment, a gate electrode of the fourth transistor of each of the first through eighth light-emitting pixel drivers is electrically connected to the one initialization control line. In this embodiment, gate electrodes of four power connection transistors electrically connected to the first through eighth light-emitting pixel drivers are electrically connected to the one first emission control line. In this embodiment, a gate electrode of the fifth transistor of each of the first through eighth light-emitting pixel drivers is electrically connected to the one second emission control line.

In an embodiment of the invention, the display device or the electronic device may further include a display driving circuit supplying data signals to data lines. The display panel may further include a non-display area disposed adjacent the display area. The circuit layer may further include the data lines extending in the second direction and transmitting the data signals, first auxiliary lines extending in the first direction, second auxiliary lines extending in the second direction and data supply lines located in the non-display area and electrically connected between the data lines and the display driving circuit. The display area may further include a first bypass side area disposed side by side with the bypass middle area in the first direction and contacting the non-display area and a second bypass side area disposed between the bypass middle area and the first bypass side area. The data supply lines may extend to the bypass middle area and the second bypass side area. The data lines may include a first data line disposed in the first bypass side area and a second data line disposed in the second bypass side area. The first auxiliary lines may include a first bypass auxiliary line electrically connected to the first data line. The second auxiliary lines may include a second bypass auxiliary line electrically connected to the first bypass auxiliary line and neighboring the second data line. A first data supply line transmitting a data signal of the first data line among the data supply lines may be electrically connected to the first data line through the first bypass auxiliary line and the second bypass auxiliary line. A second data supply line transmitting a data signal of the second data line among the data supply lines may be directly electrically connected to the second data line. Two neighboring data lines among the data lines may intersect the first light-emitting pixel driver and the second light-emitting pixel driver, respectively, and two neighboring second auxiliary lines among the second auxiliary lines may intersect the third light-emitting pixel driver and the fourth light-emitting pixel driver, respectively.

According to an embodiment of the present invention, there is provided a display device including a display panel. The display panel includes a display area in which emission areas are arranged; a circuit layer; and light emitting elements disposed in the emission areas on the circuit layer, where the emission areas are arranged in a first direction and a second direction. The circuit layer includes light-emitting pixel drivers arranged in a row along the first direction in the display area and electrically connected to the light emitting elements. A group of the light emitting elements, each disposed in a corresponding one of emission areas arranged in the first direction, the second direction, and a diagonal direction intersecting the first and second directions, are electrically connected to a corresponding one of the light-emitting pixel drivers arranged in the row along the first direction.

A display device according to an embodiment includes a substrate, a circuit layer located on the substrate, and an element layer located on the circuit layer. The substrate may include a display area in which emission areas are arranged. The circuit layer may include light-emitting pixel drivers arranged side by side with each other in a first direction and a second direction in the display area. The element layer may include light emitting elements located in the emission areas. According to an embodiment, eight of the light emitting elements located in eight of the emission areas neighboring each other in the first direction, the second direction and a diagonal direction intersecting the first direction and the second direction among the emission areas may be electrically connected to eight of the light-emitting pixel drivers arranged side by side with each other in the first direction. That is, the eight light-emitting pixel drivers electrically connected to the eight light emitting elements located in the eight emission areas may be arranged together in a single row along the first direction. Therefore, at least some wiring lines electrically connected to the eight light-emitting pixel drivers and extending in the first direction may be provided once, rather than duplicated. As a result, the total number of wiring lines in the first direction can be reduced. Accordingly, the width of each light-emitting pixel driver in an area intersecting the wiring lines of the first direction can be reduced, which may enable the resolution of the display device to be increased.

It will be understood that the foregoing description of embodiments is not intended to limit the scope of the present invention, and that various modifications and equivalent structures will be apparent to those skilled in the art.

These and/or other aspects will become apparent and more readily appreciated from the following description of the embodiments, taken in conjunction with the accompanying drawings.
FIG. 1 is a perspective view of an electronic apparatus according to an embodiment.
FIG. 2 is an exploded perspective view of the electronic apparatus illustrated in FIG. 1.
FIG. 3 is a plan view of a display device of FIG. 2.
FIG. 4 is a cross-sectional view taken along line A-A' of FIG. 3.
FIG. 5 is a layout view of part B of FIG. 3.
FIG. 6 is a block diagram of the display device of FIG. 2.
FIG. 7 is an equivalent circuit diagram of a light-emitting pixel driver of FIG. 6 according to an embodiment.
FIG. 8 is a cross-sectional view illustrating a first transistor, a second transistor, a fifth transistor, a first capacitor, a second capacitor, and a light emitting element of FIG. 7.
FIG. 9 is a layout view illustrating some light-emitting pixel drivers according to the embodiment of FIG. 5.
FIG. 10 is a plan view of a substrate of FIG. 4 according to an embodiment.
FIG. 11 is a layout view of part C of FIG. 10.
FIG. 12 is a layout view of part D of FIG. 10.
FIG. 13 is a cross-sectional view taken along line E-E' of FIG. 11.
FIGS. 14, 15, 16, 17 and 18 are plan views respectively illustrating different parts of the light-emitting pixel drivers of FIG. 9 according to an embodiment.
FIG. 19 is a block diagram of an electronic apparatus according to an embodiment.
FIG. 20 is a schematic diagram of electronic apparatuses according to various embodiments.

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity, but they nevertheless illustrate embodiments of the present invention.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of' is intended to include the meaning of "at least one selected from the group of" for the purpose of its meaning and interpretation. For example, "at least one of A and B" may be understood to mean "A, B, or A and B."

Hereinafter, embodiments will be described with reference to the accompanying drawings.

At least one embodiment of the present invention relates to a display device and an electronic device including the display device. The display device may include a display panel. The display panel may include a display area with emission areas, a circuit layer, and a light emitting elements disposed in the emission areas on the circuit layer. The emission areas may be arranged in a first direction and a second direction. The circuit layer may include light-emitting pixel drivers arranged in a row along the first direction in the display area and electrically connected to the light emitting elements. A group of the light emitting elements, each disposed in a corresponding one of the emission areas arranged in the first direction, the second direction, and a diagonal direction intersecting the first and second directions may be electrically connected to a corresponding one of the light-emitting pixel drivers arranged in the row along the first direction. By arranging the light-emitting pixel drivers in this manner, some wiring lines extending in the first direction may be provided once instead of duplicated, thereby reducing the number of wiring lines and enabling smaller pixel drivers, which in turn allows the display device to achieve higher resolution.

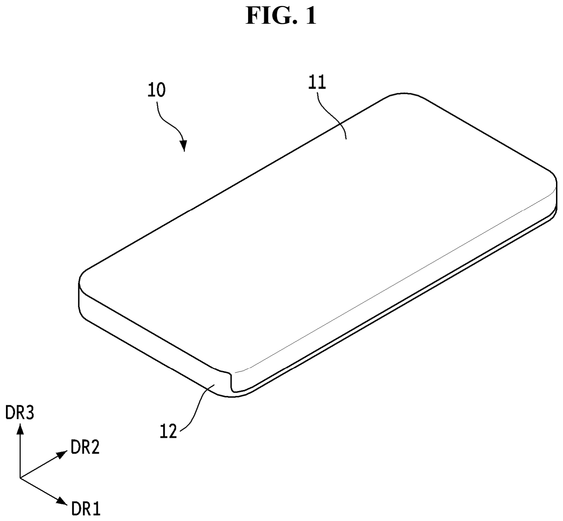

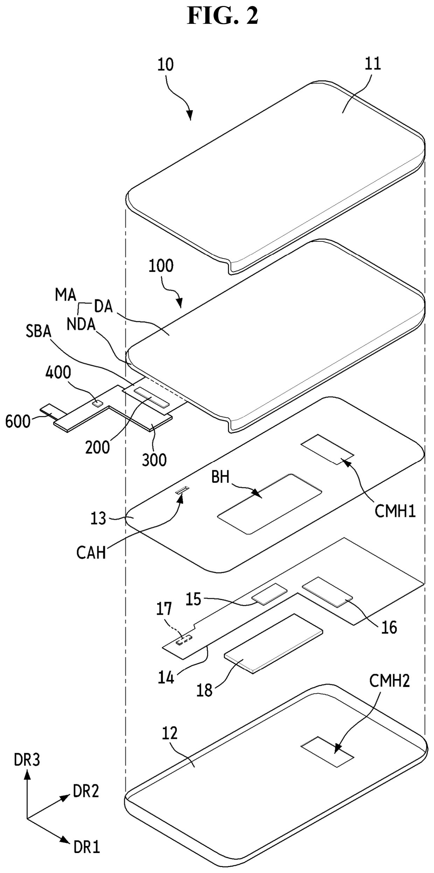

FIG. 1 is a perspective view of an electronic apparatus (or device) 10 according to an embodiment. FIG. 2 is an exploded perspective view of the electronic apparatus 10 illustrated in FIG. 1.

Referring to FIG. 1, the electronic apparatus 10 according to the embodiment may be a device configured to display an image in a display area. The electronic apparatus 10 may be portable. For example, the electronic apparatus 10 may be a portable electronic apparatus such as a mobile phone, a smartphone, a tablet personal computer (PC), a smart watch, a watch phone, a mobile communication terminal, an electronic notebook, an electronic book, a portable multimedia player (PMP), a navigation device, or an ultra-mobile PC (UMPC).

However, the electronic apparatus 10 according to the embodiment is not limited to a portable electronic apparatus and may also be a large-sized device such as a television, a notebook computer, a monitor, a billboard, or an Internet of things (IOT) device.

The electronic apparatus 10 according to the embodiment may include a cover window 11 and a bottom cover 12 provided as a housing to protect a display device 100 (see FIG. 2).

Referring to FIG. 2, the electronic apparatus 10 may further include the display device 100, a bracket 13, and a main circuit board 14 accommodated between the cover window 11 and the bottom cover 12.

The display device 100 may include a main area MA and a sub-area SBA extending from a side of the main area MA. The main area MA may include a display area DA where image display is implemented and a non-display area NDA around the display area DA.

The display device 100 may further include a display driving circuit 200 located in the sub-area SBA, a display circuit board 300 bonded to a side of the sub-area SBA, a touch driving circuit 400 mounted on the display circuit board 300, and a cable 600 extending from a side of the display circuit board 300.

Herein, a first direction DR1 may be a direction parallel to short sides of the electronic apparatus 10 in a plan view, that is, a horizontal direction of the electronic apparatus 10. A second direction DR2 may be a direction parallel to long sides of the electronic apparatus 10 in a plan view, that is, a vertical direction of the electronic apparatus 10. A third direction DR3 may be a thickness direction of the electronic apparatus 10.

The electronic apparatus 10 may have a rectangular or a substantially rectangular shape in a plan view. For example, the electronic apparatus 10 may have a rectangular planar shape having short sides in the first direction DR1 and long sides in the second direction DR2. Each corner where a short side extending in the first direction DR1 meets a long side extending in the second direction DR2 may be rounded to have a selected curvature or may be right-angled. The planar shape of the electronic apparatus 10 is not limited to a rectangular shape but may also be other polygonal shapes, a circular shape, or an oval shape.

The cover window 11 may be disposed on the display device 100 to cover an upper surface of the display device 100. The cover window 11 may serve to protect the upper surface of the display device 100.

The cover window 11 may include a light transmitting portion which is transparent and a light blocking portion which is opaque.

The light transmitting portion may overlap the display area DA of the display device 100 in the third direction DR3, and the light blocking portion may overlap the non-display area NDA of the display device 100 in the third direction DR3.

The cover window 11 may include an upper surface portion that forms an upper surface of the electronic apparatus 10, a left side surface portion that forms a left side surface of the electronic apparatus 10, and a right side surface portion that forms a right side surface of the electronic apparatus 10. The left side surface portion of the cover window 11 may extend from a left side of the upper surface portion, and the right side surface portion may extend from a right side of the upper surface portion.

Each of the upper surface portion, the left side surface portion, and the right side surface portion of the cover window 11 may include a light transmitting portion and a light blocking portion.

The light transmitting portion of the cover window 11 may be located in most of each of the upper surface portion, the left side surface portion, and the right side surface portion of the cover window 11.

The light blocking portion of the cover window 11 may be located at an upper edge and lower edge of the upper surface portion of the cover window 11, at an upper edge, left edge and lower edge of the left side surface portion of the cover window 11, and at an upper edge, right edge and lower edge of the right side surface portion of the cover window 11.

The display device 100 may be located under the cover window 11. That is, the cover window 11 may be located on the display device 100.

The display device 100 may include an upper surface portion facing the upper surface portion of the cover window 11, a left side surface portion facing the left side surface portion of the cover window 11, and a right side surface portion facing the right side surface portion of the cover window 11. The left side surface portion of the display device 100 may extend from a left side of the upper surface portion, and the right side surface portion may extend from a right side of the upper surface portion.

The display device 100 may include the main area MA which serves as a display surface and the sub-area SBA which extends from at least a portion of a side of the main area MA. The main area MA may include the display area DA which displays an image and the non-display area NDA around the display area DA. The display area DA may be located in most of the main area MA. The display area DA may be located in the center of the main area MA. In other words, each of the upper surface portion, the left side surface portion, and the right side surface portion of the display device 100 may include the display area DA and the non-display area NDA. The display area DA may be located in most of each of the upper surface portion, the left side surface portion, and the right side surface portion of the display device 100.

The non-display area NDA may be located outside the display area DA. The non-display area NDA may be an edge area of the main area MA. The non-display area NDA may be located at an upper edge and lower edge of the upper surface portion of the display device 100, at an upper edge, left edge and lower edge of the left side surface portion of the display device 100, and at an upper edge, right edge and lower edge of the right side surface portion of the display device 100.

The sub-area SBA may extend from a side of the main area MA in the second direction DR2. A length of the sub-area SBA in the first direction DR1 may be equal to or smaller than a length of the main area MA in the first direction DR1. A length of the sub-area SBA in the second direction DR2 may be smaller than a length of the main area MA in the second direction DR2, but embodiments of the present invention are not limited thereto. When a portion of the sub-area SBA is changed into a bent shape, the other portion of the sub-area SBA may be overlapped by the main area MA in the third direction DR3.

The display driving circuit 200 may be mounted on the sub-area SBA, and the display circuit board 300 may be attached to the sub-area SBA. An end of the display circuit board 300 may be attached onto pads located at a lower edge of the sub-area SBA of the display device 100 using an anisotropic conductive film.

The display circuit board 300 may be a flexible printed circuit board that can be bent, a rigid printed circuit board that maintains a flat shape, or a composite printed circuit board including both a rigid printed circuit board and a flexible printed circuit board.

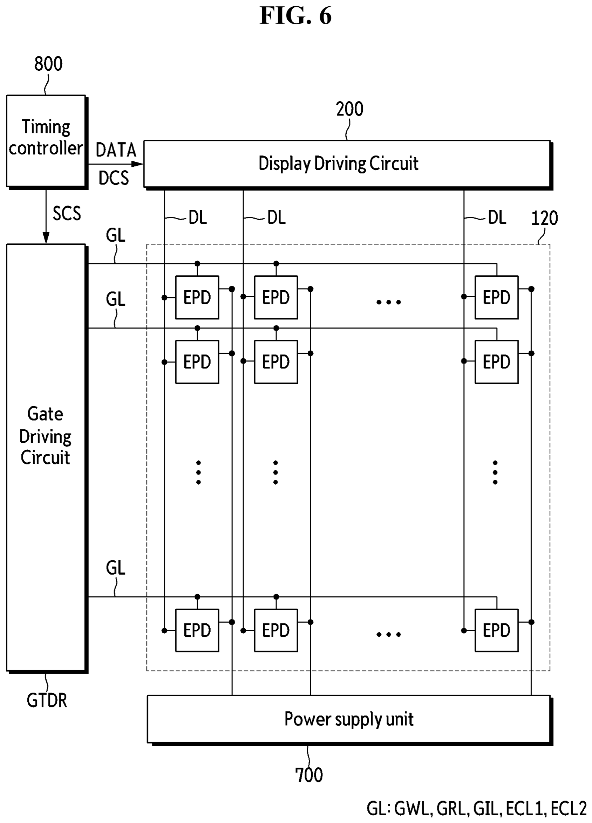

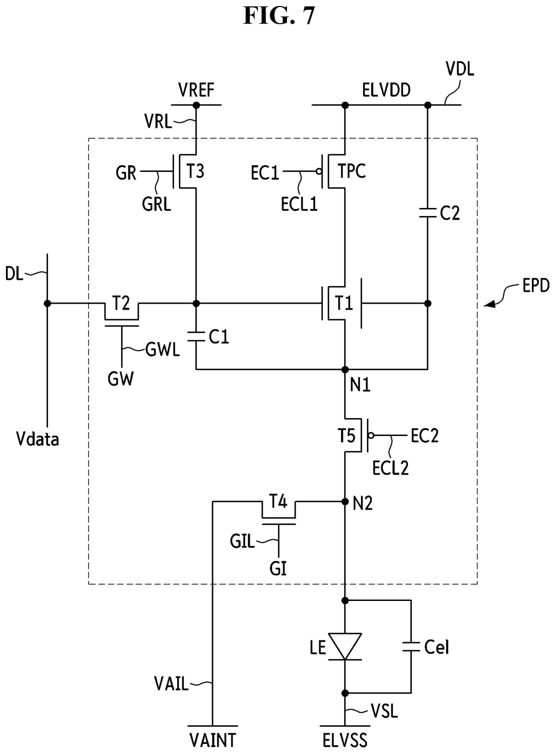

The display driving circuit 200 may transmit respective data signals Vdata (see FIG. 7) of light-emitting pixel drivers EPD (see FIG. 6) of the display area DA to data lines DL (see FIG. 6) based on control signals, power and driving voltages supplied through the display circuit board 300.

The display driving circuit 200 may be provided as an integrated circuit and may be mounted on the sub-area SBA of the display device 100 using a chip on glass (COG) method, a chip on plastic (COP) method, or an ultrasonic method. However, this is merely an example, and embodiments are not limited to this example. For example, the display driving circuit 200 may also be mounted on the display circuit board 300.

According to an embodiment, the touch driving circuit 400 may be further mounted on the sub-area SBA of the display device 100. Alternatively, as illustrated in FIG. 2, the touch driving circuit 400 may be mounted on the display circuit board 300.

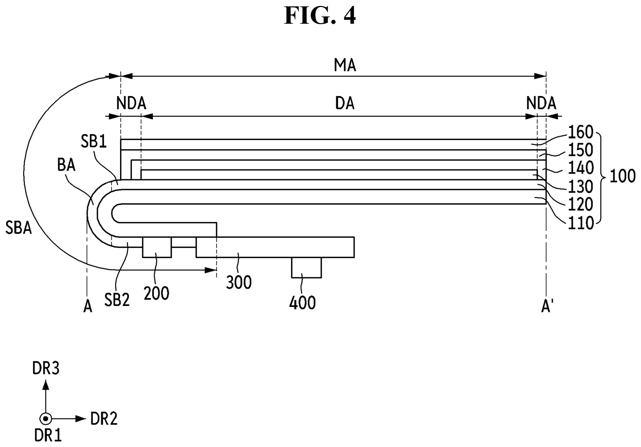

The touch driving circuit 400 may be electrically connected to a touch sensor layer 150 (see FIG. 4) of the display device 100.

As illustrated in FIG. 2, the bracket 13 may be located under the display device 100.

The bracket 13 may include plastic or metal. The bracket 13 may include a first camera hole CMH1 into which a camera device 16 is inserted, a battery hole BH in which a battery 18 is placed, and a cable hole CAH through which the cable 600 connected to the display circuit board 300 passes.

The main circuit board 14 and the battery 18 may be located under the bracket 13. The main circuit board 14 may be a printed circuit board or a flexible printed circuit board. The main circuit board 14 may include a main processor 15, the camera device 16, and a main connector 17. The main processor 15 may be formed as an integrated circuit.

The camera device 16 may be located on both an upper surface and a lower surface of the main circuit board 14. The main processor 15 may be located on the upper surface of the main circuit board 14, and the main connector 17 may be located on the lower surface of the main circuit board 14. The main processor 15 may control all functions of the electronic apparatus 10.

For example, the main processor 15 may output digital video data to the display driving circuit 200 through the display circuit board 300 so that the display device 100 can display an image. In addition, the main processor 15 may receive touch data including a user's touch coordinates from the touch driving circuit 400, determine whether the user has touched or is in proximity, and then perform an operation corresponding to the user's touch input or proximity input. For example, the main processor 15 may execute an application or perform an operation indicated by an icon touched by the user. The main processor 15 may be an application processor, a central processing unit, or a system chip formed as an integrated circuit.

The camera device 16 processes an image frame such as a still image or a moving image obtained by an image sensor in a camera mode and outputs the processed image frame to the main processor 15.

The cable 600 passing through the cable hole CAH of the bracket 13 may be connected to the main connector 17. Accordingly, the main circuit board 14 may be electrically connected to the display circuit board 300.

The battery 18 may be placed not to overlap the main circuit board 14 in the third direction DR3. The battery 18 may overlap the battery hole BH of the bracket 13 in the third direction DR3.

In addition, the main circuit board 14 may be further equipped with a mobile communication module that can transmit and receive wireless signals to and from at least one of a base station, an external terminal, and a server over a mobile communication network. The wireless signals may include voice signals, video call signals, or various forms of data resulting from transmission/reception of text/multimedia messages.

The bottom cover 12 may be located under the main circuit board 14 and the battery 18. The bottom cover 12 may be fastened and fixed to the bracket 13. The bottom cover 12 may form an upper side surface, a lower side surface, and a lower surface of the electronic apparatus 10. The bottom cover 12 may include plastic, metal, or both plastic and metal.

The bottom cover 12 may include a second camera hole CMH2 which exposes a lower surface of the camera device 16. The position of the camera device 16 and the positions of the first camera hole CMH1 and the second camera hole CMH2 corresponding to the camera device 16 are not limited to those illustrated in FIG. 2.

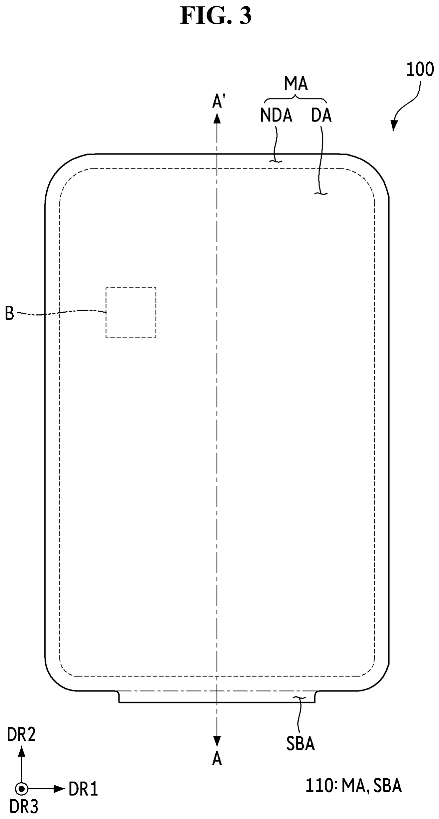

FIG. 3 is a plan view of the display device 100 of FIG. 2. FIG. 4 is a cross-sectional view taken along line A-A' of FIG. 3.

Referring to FIGS. 3 and 4, a display device 100 according to an embodiment is a device for displaying moving images or still images. The display device 100 may be used as a display screen in portable electronic apparatuses such as mobile phones, smartphones, tablet PCs, smart watches, watch phones, mobile communication terminals, electronic notebooks, electronic books, PMPs, navigation devices and UMPCs, as well as in various products such as televisions, notebook computers, monitors, billboards, and IoT devices.

The display device 100 may be a light emitting display device such as an organic light emitting display device using an organic light emitting diode, a quantum dot light emitting display device including a quantum dot light emitting layer, an inorganic light emitting display device including an inorganic semiconductor, or a micro- or nano-light emitting display device using a micro- or nano-light emitting diode. The display device 100 as an organic light emitting display device will be mainly described below, but embodiments are not limited thereto. For example, the present invention is also applicable to display devices including an organic insulating material, an organic light emitting material, and a metal material.

The display device 100 may be formed flat, but embodiments are not limited thereto. For example, the display device 100 may include a curved portion formed at left and right ends and having a constant or varying curvature. In addition, the display device 100 may be formed to be flexible so that it can be curved, bent, folded, or rolled.

Referring to FIG. 3, at least a surface of the display device 100 includes the main area MA which emits light for image display.

The display area DA may be shaped like a rectangular plane having short sides in the first direction DR1 and long sides in the second direction DR2 intersecting the first direction DR1. Each corner where a short side extending in the first direction DR1 meets a long side extending in the second direction DR2 may be rounded to have a selected curvature or may be right-angled. The planar shape of the display area DA is not limited to a quadrangular shape but may also be other polygonal shapes, a circular shape, or an oval shape. The display area DA may be located in most of the main area MA. The display area DA may be located in the center of the main area MA.

Referring to FIG. 4, the display device 100 may further include the sub-area SBA protruding in the second direction DR2 from at least a portion of a side of the main area MA. When a portion of the sub-area SBA is changed into a bent shape, the other portion of the sub-area SBA may be disposed on a back surface of the display device 100.

According to an embodiment, the display device 100 includes a substrate 110, a circuit layer 120 located on the substrate 110, and an element layer 130 located on the circuit layer 120.

The display device 100 may further include a sealing layer 140 located on the element layer 130 and a touch sensor layer 150 located on the sealing layer 140. The display device 100 may further include a polarizing layer 160 located on the touch sensor layer 150 to reduce reflection of external light. The substrate 110 may include the main area MA corresponding to the display surface and the sub-area SBA extending in the second direction DR2 from at least a portion of a side of the main area MA. The main area MA of the substrate 110 may include the display area DA emitting light and the non-display area NDA located around the display area DA.

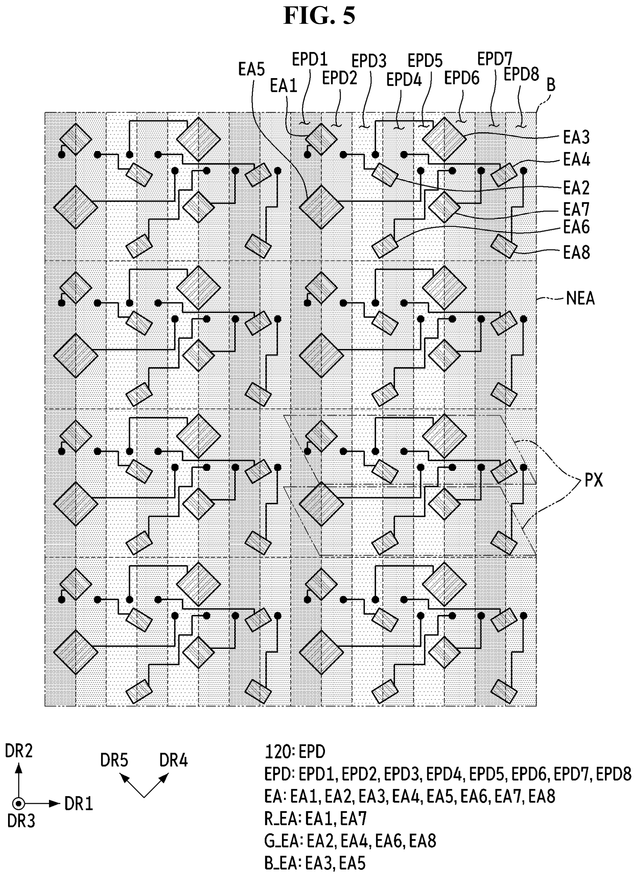

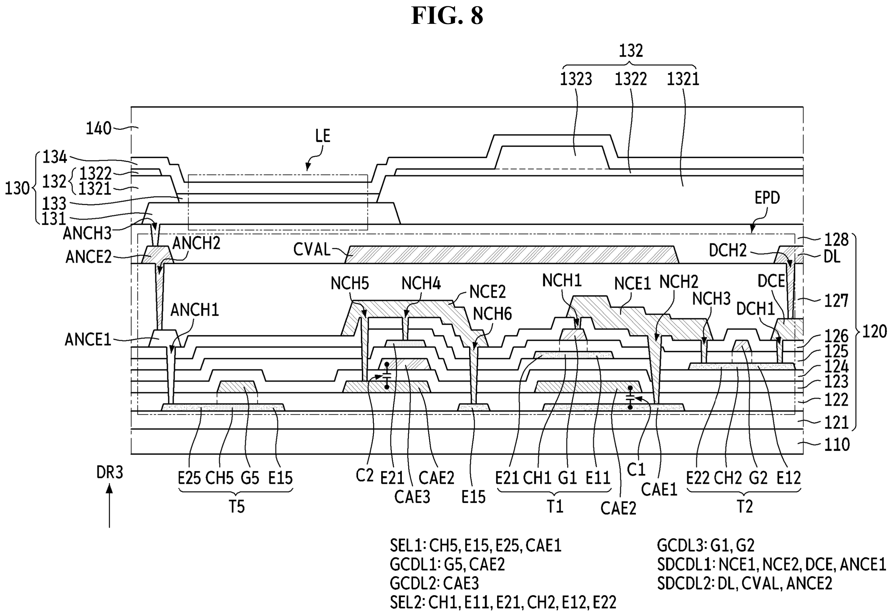

According to an embodiment, the element layer 130 may include light emitting elements LE (see FIGS. 7 and 8) located in emission areas EA (see FIG. 5), respectively.

The circuit layer 120 may include light-emitting pixel drivers EPD (see FIG. 5) electrically connected to the light emitting elements LE and data lines DL (see FIGS. 6 and 7) transmitting data signals Vdata (see FIG. 7) of the light-emitting pixel drivers EPD (see FIG. 5).

The sealing layer 140 may cover the element layer 130. The sealing layer 140 may include a structure in which two or more inorganic layers and at least one organic layer are alternately stacked.

The touch sensor layer 150 may be located on the sealing layer 140 and may correspond to the main area MA. The touch sensor layer 150 may include touch electrodes for detecting a touch of a person or an object.

The polarizing layer 160 blocks external light reflected from the touch sensor layer 150, the sealing layer 140, the element layer 130, the circuit layer 120 and interfaces between the touch sensor layer 150, the sealing layer 140, the element layer 130 and the circuit layer 120 to prevent a reduction in image visibility due to reflection of the external light.

When a portion of the sub-area SBA is changed into a bent shape, the display driving circuit 200 mounted on the sub-area SBA and the display circuit board 300 connected to a side of the sub-area SBA may be disposed under the substrate 110.

The display driving circuit 200 may be electrically connected to the data lines DL (see FIGS. 6 and 7) of the circuit layer 120. The display driving circuit 200 may transmit the data signals Vdata (see FIG. 7) of the light-emitting pixel drivers EPD (see FIG. 5) through the data lines DL based on control signals and power voltages supplied from the display circuit board 300.

The display driving circuit 200 may be provided as an integrated circuit and may be mounted on the sub-area SBA of the display device 100 using a COG method, a COP method, or an ultrasonic method. However, this is merely an example, and embodiments are not limited thereto. For example, the display driving circuit 200 may also be mounted on the display circuit board 300.

An end of the display circuit board 300 may be attached onto pads located at an edge of the sub-area SBA of the display device 100 using an anisotropic conductive film.

The display circuit board 300 may be a flexible printed circuit board that can be bent, a rigid printed circuit board that maintains a flat shape, or a composite printed circuit board including both a rigid printed circuit board and a flexible printed circuit board.

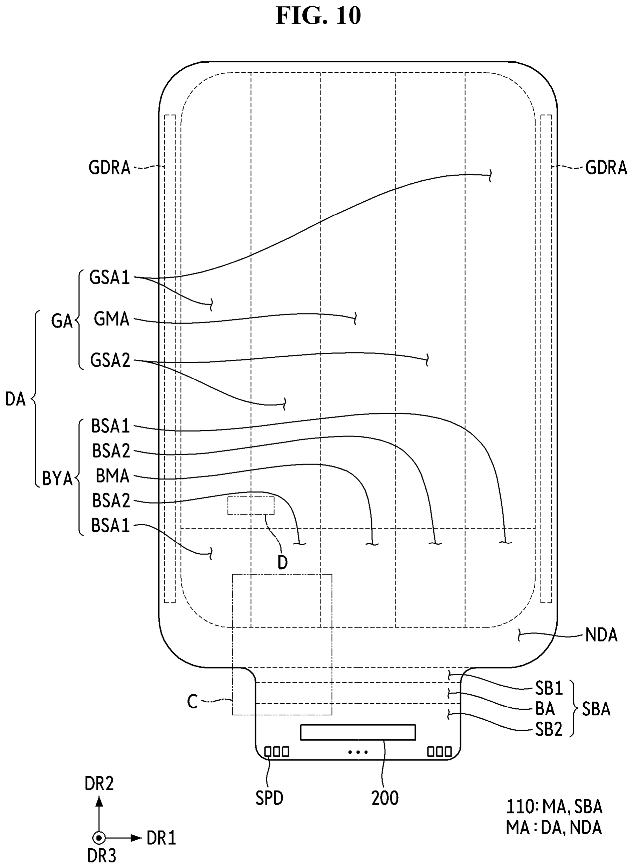

The display circuit board 300 may be connected to signal pads SPD (see FIG. 10) located at a side of the sub-area SBA.

The touch driving circuit 400 may be mounted on the display circuit board 300. The touch driving circuit 400 may be electrically connected to the touch sensor layer 150 of the display device 100. The touch driving circuit 400 may apply touch driving signals to driving lines of the touch sensor layer 150 and receive touch sensing signals from sensing lines. In addition, the touch driving circuit 400 may determine whether a user's touch or proximity has occurred by sensing amounts of charge change in capacitances based on the touch sensing signals.

The user's touch may indicate that an object, such as the user's finger or a pen, directly touches an upper surface of the cover window located on the touch sensor layer 150. The user's proximity may indicate that an object, such as the user's finger or a pen, hovers above the upper surface of the cover window. The touch driving circuit 400 may output touch data including the user's touch coordinates to the main processor 15 (see FIG. 2).

As used herein, the term display panel may refer to the layered structure illustrated in FIG. 3, including the substrate 110, the circuit layer 120, and the element layer 130 (optionally together with overlying layers such as the sealing layer 140, touch sensor layer 150, and polarizing layer 160), which collectively define the panel portion of the display device 100 that generates and displays images.

FIG. 5 is a layout view of part B of FIG. 3. As illustrated in FIG. 5, the display area DA may include emission areas EA which emit light and a non-emission area NEA which is an area between the emission areas EA and does not emit light. The non-emission area NEA may surround the emission areas EA.

Each of the emission areas EA may be a unit area that emits light of a wavelength band corresponding to one of two or more different colors with a luminance corresponding to an image signal. For example, a first one of the emission areas EA may emit red light, a second one of the emission areas EA may emit green light, and a third one of the emission areas EA may emit blue light, with the luminance of each controlled by the corresponding image signal.

In an embodiment, each of the emission areas EA has a quadrangular shape. For example, as illustrated in FIG. 5, each of the emission areas EA may have a rhombus or diamond shape. However, this is merely an example, and the planar shape of each of the emission areas EA according to an embodiment is not limited to the planar shape illustrated in FIG. 5. That is, the emission areas EA may also have a polygonal shape, such as a rectangle, a square, a hexagon or an octagon other than a rhombus, or an oval shape in a plan view. The emission areas EA may include rhombus-shaped regions that differ in size and internal angles, such that some are relatively small and narrow while others are larger and wider, as well as rectangular regions of varying sizes.

According to an embodiment, the emission areas EA may be arranged side by side with each other in the first direction DR1, the second direction DR2, and diagonal directions DR4 and DR5 intersecting the first direction DR1 and the second direction DR2.

The diagonal directions DR4 and DR5 may include a first diagonal direction DR4 between a lower left side and an upper right side and a second diagonal direction DR5 between a lower right side and an upper left side. For a concise and easy description of an example, the second diagonal direction DR5 may be referred to as a diagonal direction (DR4, DR5) below. For example, the diagonal directions DR4 and DR5 may include a first diagonal direction DR4 extending from a lower-left corner of the display area DA to an upper-right corner of the display area DA, and a second diagonal direction DR5 extending from a lower-right corner of the display area DA to an upper-left corner of the display area DA.

According to an embodiment, the emission areas EA include eight emission areas EA1 through EA8 neighboring each other in the first direction DR1, the second direction DR2, and the diagonal direction (DR4, DR5) intersecting the first direction DR1 and the second direction DR2. For example, a first emission area EA1 may be directly adjacent to a third emission area EA3 along the first direction DR1, a fifth emission area EA5 along the second direction DR2, and a second emission area EA2 along the diagonal direction DR5, with the remaining emission areas EA4, and EA6 through EA8 positioned to complete a group of eight neighboring emission areas.

The eight emission areas EA1 through EA8 may include a first emission area EA1, a second emission area EA2 neighboring the first emission area EA1 in the diagonal direction DR5, a third emission area EA3 neighboring the first emission area EA1 in the first direction DR1, a fourth emission area EA4 neighboring the third emission area EA3 in the diagonal direction DR5 and neighboring the second emission area EA2 in the first direction DR1, a fifth emission area EA5 neighboring the first emission area EA1 in the second direction DR2, a sixth emission area EA6 neighboring the fifth emission area EA5 in the diagonal direction DR5 and neighboring the second emission area EA2 in the second direction DR2, a seventh emission area EA7 neighboring the fifth emission area EA5 in the first direction DR1 and neighboring the third emission area EA3 in the second direction DR2, and an eighth emission area EA8 neighboring the seventh emission area EA7 in the diagonal direction DR5, neighboring the sixth emission area EA6 in the first direction DR1 and neighboring the fourth emission area EA4 in the second direction DR2.

According to an embodiment, the emission areas EA may include first color emission areas R_EA which emit light of a first wavelength band, second color emission areas G_EA which emit light of a second wavelength band lower than the first wavelength band, and third color emission areas B_EA which emit light of a third wavelength band lower than the second wavelength band.

For example, the first wavelength band may be about 600 nanometers (nm) to about 750 nm and may correspond to red. The second wavelength band may be about 480 nm to about 560 nm and may correspond to green. The third wavelength band may be about 370 nm to about 460 nm and may correspond to blue.

However, this is merely an example, and the first wavelength band, the second wavelength band, and the third wavelength band according to various embodiment are not limited thereto.

Since the emission areas EA include the first color emission areas R_EA, the second color emission areas G_EA and the third color emission areas B_EA, each unit pixel PX may be formed by a combination of one or more first color emission areas R_EA, one or more second color emission areas G_EA, and one or more third color emission areas B_EA adjacent to each other among the emission areas EA.

Each unit pixel PX may be a unit that displays various colors including white. That is, light of various colors displayed by each pixel unit PX may be realized as a mixture of light emitted from two or more emission areas EA included in each unit pixel PX.

In an embodiment, the third color emission areas B_EA have a greater width or area than the first color emission areas R_EA, and the first color emission areas R_EA have a greater width or area than the second color emission areas G_EA. However, this is merely an example, and the width and/or area of each of the emission areas EA is not limited to the width illustrated in FIG. 5.

According to an embodiment, each of the first emission area EA1 and the seventh emission area EA7 is a first color emission area R_EA, which emits light of the first wavelength band.

Further in this embodiment, each of the second emission area EA2, the fourth emission area EA4, the sixth emission area EA6, and the eighth emission area EA8 is a second color emission area G_EA, which emits light of the second wavelength band.

Additionally in this embodiment, each of the third emission area EA3 and the fifth emission area EA5 is a third color emission area B_EA, which emits light of the third wavelength band.

According to an embodiment, the circuit layer 120 may include light-emitting pixel drivers EPD arranged in the first direction DR1 and the second direction DR2 in the display area DA (see FIG. 3).

The light-emitting pixel drivers EPD may be electrically connected to light emitting elements LE (see FIGS. 7 and 8) of the element layer 130 (see FIG. 4) located in the emission areas EA, respectively.

According to an embodiment, light emitting elements LE located in the eight emission areas EA1 through EA8 neighboring each other in the first direction DR1, the second direction DR2 and the diagonal direction (DR4, DR5) intersecting the first direction DR1 and the second direction DR2 are electrically connected to eight light-emitting pixel drivers EPD1 through EPD8 arranged in the first direction DR1 among the light-emitting pixel drivers EPD of the circuit layer 120.

In other words, the eight light-emitting pixel drivers EPD1 through EPD8 electrically connected to the light emitting elements LE located in the eight emission areas EA1 through EA8 neighboring each other in the first direction DR1, the second direction DR2 and the diagonal direction (DR4, DR5) intersecting the first direction DR1 and the second direction DR2 are not arranged in the first direction DR1 and the second direction DR2, but are arranged only in the first direction DR1, unlike the eight emission areas EA1 through EA8. In an embodiment, although the eight emission areas EA1 through EA8 neighbor one another in the first direction DR1, the second direction DR2, and the diagonal directions DR4 and DR5, the eight light-emitting pixel drivers EPD1 through EPD8 that drive those emission areas are not distributed across both directions. In this embodiment, the eight light-emitting pixel drivers EPD1 through EPD8 are arranged together in a single row along the first direction DR1.

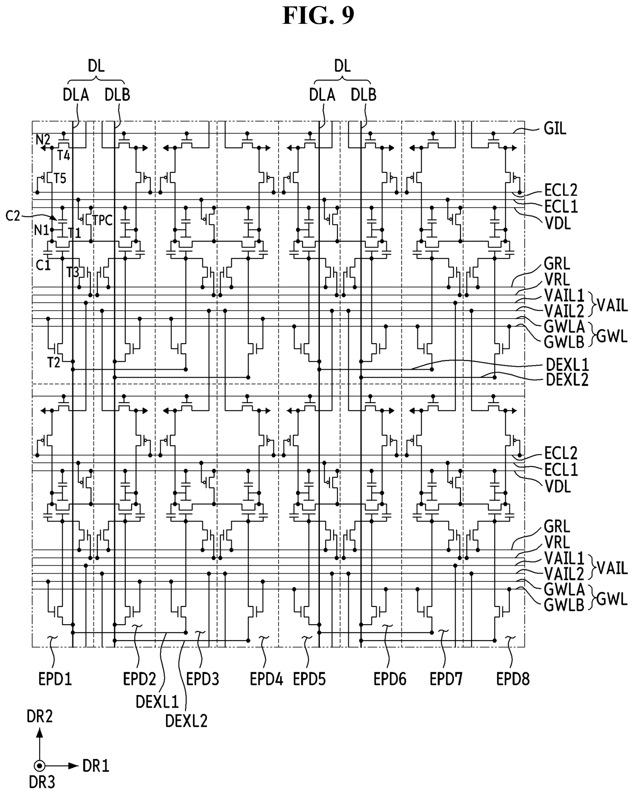

In an embodiment, as will be described later with reference to FIG. 9, at least some lines (e.g., wiring lines) electrically connected to the eight light-emitting pixel drivers EPD1 through EPD8 and extending in the first direction DR1 (hereinafter, referred to as "lines of the first direction DR1") may be arranged only one each, not two. Therefore, the number of lines of the first direction DR1 can be reduced.

For example, according to an embodiment of FIG. 9, the lines of the first direction DR1 may include a scan write line GWL, a reset control line GRL, an initialization control line GIL, a first emission control line ECL1, a second emission control line ECL2, a reference voltage line VRL, a first power line VDL, a first initialization voltage line VAIL1, and a second initialization voltage line VAIL2. For example, within the group of eight emission areas EA1 through EA8, the eight light-emitting pixel drivers EPD1 through EPD8 arranged in a single row along the first direction DR1 may be connected by a single reset control line GRL extending in the first direction DR1, rather than requiring two parallel reset control lines.

As described above, according to an embodiment, the eight light-emitting pixel drivers EPD1 through EPD8 electrically connected to the light emitting elements LE located in the eight emission areas EA1 through EA8 neighboring each other in the first direction DR1, the second direction DR2 and the diagonal direction (DR4, DR5) intersecting the first direction DR1 and the second direction DR2 are arranged only in the first direction DR1. Therefore, the number of lines of the first direction DR1 electrically connected to the eight light-emitting pixel drivers EPD1 through EPD8 can be reduced. Accordingly, in each of the light-emitting pixel drivers EPD, a width of an area intersecting the lines of the first direction DR1 can be reduced, which may enable the display device 100 to have a higher resolution.

FIG. 6 is a block diagram of the display device 100 of FIG. 2. Referring to FIG. 6, the circuit layer 120 of the display device 100 according to the embodiment may include light-emitting pixel drivers EPD electrically connected to light emitting elements LE (see FIG. 7) located in emission areas EA (see FIG. 5) and data lines DL transmitting data signals Vdata (see FIG. 7) to the light-emitting pixel drivers EPD.

The circuit layer 120 may further include one or more gate lines GL which transmit one or more gate signals to the light-emitting pixel drivers EPD.

According to an embodiment, the display device 100 may further include the display driving circuit 200 which outputs the data signals Vdata (see FIG. 7) of the light-emitting pixel drivers EPD to the data lines DL to control the luminance of each of the light emitting elements LE (see FIG. 7).

According to an embodiment, the display device 100 may further include a gate driving circuit GTDR that outputs gate signals to the gate lines GL, a power supply unit 700 (e.g., a power supply or power supply circuit) that supplies power and driving voltages to the light-emitting pixel drivers EPD, and a timing controller 800 which controls the driving timing of each of the display driving circuit 200 and the gate driving circuit GTDR.

The timing controller 800 receives an image signal supplied from the outside of the display device 100.

The timing controller 800 may output image data DATA and a data control signal DCS to the display driving circuit 200.

The timing controller 800 may generate a scan control signal for controlling the operation timing of the gate driving circuit GTDR.

The display driving circuit 200 may convert the image data DATA into analog data voltages and output the analog data voltages to the data lines DL.

The gate driving circuit GTDR may generate gate signals according to the scan control signal SCS and sequentially output the gate signals to the gate lines GL.

The gate lines GL may include a scan write line GWL which transmits a scan write signal GW (see FIG. 7), a reset control line GRL which transmits a reset control signal GR (see FIG. 7), an initialization control line GIL which transmits an initialization control signal GI (see FIG. 7), a first emission control line ECL1 which transmits a first emission control signal EC1 (see FIG. 7), and a second emission control line ECL2 which transmits a second emission control signal EC2 (see FIG. 7).

Each of the gate signals may have a pulse that changes to a first gate-level voltage or a second gate-level voltage.

The power supply unit 700 may supply various power and driving voltages necessary for powering and driving the light-emitting pixel drivers EPD.

For example, the power supply unit 700 may supply a first power voltage ELVDD (see FIG. 7) and second power voltage ELVSS (see FIG. 7) for generating a driving signal to be transmitted to the light emitting elements LE, a reference voltage VREF (see FIG. 7) for initializing the light-emitting pixel drivers EPD, and an initialization voltage VAINT (see FIG. 7) for initializing the light emitting elements LE (see FIG. 7).

FIG. 7 is an equivalent circuit diagram of a light-emitting pixel driver EPD of FIG. 6 according to an embodiment.

Referring to FIG. 7, the circuit layer 120 (see FIG. 4) may include a first power line VDL which transmits the first power voltage ELVDD to light-emitting pixel drivers EPD, a second power line VSL which transmits the second power voltage ELVSS to light emitting elements LE, a reference voltage line VRL which transmits the reference voltage VREF to the light-emitting pixel drivers EPD, and an initialization voltage line VAIL which transmits the initialization voltage VAINT.

The light emitting elements LE of the element layer 130 (see FIG. 4) may be electrically connected between the light-emitting pixel drivers EPD and the second power voltage ELVSS.

That is, one of the light emitting elements LE may be electrically connected between one of the light-emitting pixel drivers EPD of the circuit layer 120 and the second power voltage ELVSS.

In an embodiment, the second power voltage ELVSS is at a lower voltage level than the first power voltage ELVDD. In an embodiment, the second power voltage ELVSS is a ground voltage. In another embodiment, the first power voltage ELVDD is a positive voltage and the second power voltage ELVSS is a negative voltage.

An anode of a light emitting element LE may be electrically connected to a light-emitting pixel driver EPD, and a cathode of the light emitting element LE may be electrically connected to the second power line VSL, which transmits the second power voltage ELVSS.

A capacitor Cel connected in parallel to the light emitting element LE represents a parasitic capacitance between the anode and the cathode.

The circuit layer 120 may include at least one of a scan write line GWL that transmits a scan write signal GW, a reset control line GRL that transmits a reset control signal GR, an initialization control line GIL that transmits an initialization control signal GI, a first emission control line ECL1 that transmits a first emission control signal EC1, and a second emission control line ECL2 that transmits a second emission control signal EC2.

According to an embodiment, the circuit layer 120 include a power connection transistor TPC electrically connected between two light-emitting pixel drivers EPD neighboring each other in the first direction DR1 among the light-emitting pixel drivers EPD and the first power line VDL. For example, one power connection transistor TPC may connect the first power line VDL to two neighboring light-emitting pixel drivers EPD1 and EPD2 arranged in the first direction DR1, thereby supplying the same power line to both drivers.

Each of the light-emitting pixel drivers EPD may include a first transistor T1 electrically connected between the power connection transistor TPC and a first node N1 and generating a driving current for driving the light emitting element LE.

A first electrode of the power connection transistor TPC may be electrically connected to the first power line VDL, and a second electrode of the power connection transistor TPC may be electrically connected to a first electrode of the first transistor T1 of each of the two neighboring light-emitting pixel drivers EPD.

According to an embodiment, each of the light-emitting pixel drivers EPD of the circuit layer 120 may further include two or more transistors T2 through T5 and one or more capacitors C1 and C2, which are electrically connected to the first transistor T1 or the light emitting element LE.

That is, each of the light-emitting pixel drivers EPD may further include a second transistor T2 electrically connected between a data line DL and a gate electrode of the first transistor T1, a third transistor T3 electrically connected between the reference voltage line VRL and the gate electrode of the first transistor T1, a fourth transistor T4 electrically connected between the initialization voltage line VAIL and a second node N2, a fifth transistor T5 electrically connected between the first node N1 and the second node N2, a first capacitor C1 electrically connected between the gate electrode of the first transistor T1 and the first node N1, and a second capacitor C2 electrically connected between the first node N1 and the first power line VDL.

The first node N1 may be electrically connected to a second electrode of the first transistor T1.

The second node N2 may be electrically connected to the light emitting element LE.

The second transistor T2 may be turned on by the scan write signal GW of the scan write line GWL. For example, the scan write signal GW may be applied to a gate terminal of the second transistor T2.

When the second transistor T2 is turned on, a data signal Vdata of the data line DL may be transmitted to the gate electrode of the first transistor T1.

When a voltage difference between the gate electrode of the first transistor T1 and the second electrode of the first transistor T1 becomes equal to or greater than a threshold voltage of the first transistor T1 due to the data signal Vdata applied to the gate electrode of the first transistor T1, the first transistor T1 may be turned on. Accordingly, a drain-source current of the first transistor T1 may be generated with a magnitude corresponding to the data signal Vdata.

The third transistor T3 may be turned on by the reset control signal GR of the reset control line GRL. For example, the reset control signal GR may be applied to a gate terminal of the third transistor T3.

When the third transistor T3 is turned on, the potential of the gate electrode of the first transistor T1 may be reset to the reference voltage VREF of the reference voltage line VRL.

The fourth transistor T4 may be turned on by the initialization control signal GI of the initialization control line GIL. For example, the initialization control signal GI may be applied to a gate terminal of the fourth transistor T4.

When the fourth transistor T4 is turned on, the potential of the anode of the light emitting element LE may be initialized to the initialization voltage VAINT of the initialization voltage line VAIL.

The first transistor T1 may be electrically connected to the first power line VDL (see FIG. 7) through the power connection transistor TPC.

The power connection transistor TPC may be turned on by the first emission control signal EC1 of the first emission control line ECL1. For example, the first emission control signal EC1 may be applied to a gate terminal of the power connection transistor TPC.

When the power connection transistor TPC is turned on, the first power voltage ELVDD of the first power line VDL may be transmitted to the first electrode of the first transistor T1.

The fifth transistor T5 may be turned on by the second emission control signal EC2 of the second emission control line ECL2. For example, the second emission control signal EC1 may be applied to a gate terminal of the fifth transistor T5.

When the fifth transistor T5 is turned on, the drain-source current of the first transistor T1, which is generated with the magnitude corresponding to the data signal Vdata, may be transmitted as the driving current to the light emitting element LE through the fifth transistor T5.

Accordingly, the light emitting element LE may emit light with a luminance corresponding to the data signal Vdata.

The first capacitor C1 may be electrically connected between the gate electrode of the first transistor T1 and the second electrode of the first transistor T1.

Accordingly, the first capacitor C1 may be charged with the data signal Vdata applied to the gate electrode of the first transistor T1, and the first transistor T1 may remain turned on for a selected period of time due to the voltage that charges the first capacitor C1.

The second capacitor C2 may be electrically connected between the second electrode of the first transistor T1 and the first power line VDL.

The voltage of the first capacitor C1 may correspond to a potential difference between the gate electrode of the first transistor T1 and the second electrode of the first transistor T1 and may be changed by the data signal Vdata.

In addition, the voltage of the first capacitor C1 may be divided by the second capacitor C2. Accordingly, the potential difference between the gate electrode of the first transistor T1 and the second electrode of the first transistor T1 may be maintained at the magnitude corresponding to the data signal Vdata.

According to an embodiment, the first transistor T1 may include a gate electrode and a gate additional electrode facing opposite surfaces of a channel.

The gate electrode of the first transistor T1 may be electrically connected to the second transistor T2.

The gate additional electrode of the first transistor T1 may be electrically connected to the second electrode of the first transistor T1.

Accordingly, when the first transistor T1 is turned on in response to the data signal Vdata applied to the gate electrode of the first transistor T1, a portion of the channel of the first transistor T1, which is adjacent to the gate electrode, may be activated, but the other portion of the channel of the first transistor T1, which is adjacent to the gate additional electrode, may not be activated.

Therefore, electron mobility in the channel of the first transistor T1 may be reduced, and thus the slope of a current curve representing the relationship between the voltage of the gate electrode of the first transistor T1 and the source-drain current may become more gradual. Accordingly, the driving voltage range of the first transistor T1 may be widened, which may make it easier to control luminance.

As illustrated in FIG. 7, the first transistor T1 may be an N-type Metal-Oxide-Semiconductor Field-Effect Transistor (MOSFET).

Like the first transistor T1, the second through fifth transistors T2 through T5 and the power connection transistor TPC may be N-type MOSFETs.

Alternatively, as illustrated in FIG. 7, at least some of the second through fifth transistors T2 through T5 and the power connection transistor TPC may be P-type MOSFETs.

For example, the power connection transistor TPC and the fifth transistor T5 may be P-type MOSFETs, and the second transistor T2, the third transistor T3 and the fourth transistor T4 may be N-type MOSFETs.

According to an embodiment, the circuit layer 120 may include a first semiconductor layer SEL1 (see FIG. 8) for forming P-type MOSFETs and a second semiconductor layer SEL2 (see FIG. 8) for forming N-type MOSFETs.

FIG. 8 is a cross-sectional view illustrating the first transistor T1, the second transistor T2, the fifth transistor T5, the first capacitor C1, the second capacitor C2, and the light emitting element LE of FIG. 7.

Referring to FIG. 8, the display device 100 according to the embodiment may include the substrate 110, the circuit layer 120 disposed on the substrate 110, and the element layer 130 disposed on the circuit layer 120.

The display device 100 may further include the sealing layer 140 disposed on the element layer 130.

According to an embodiment, the circuit layer 120 may include the first semiconductor layer SEL1 disposed on the substrate 110, a first interlayer insulating layer 124 disposed on the first semiconductor layer SEL1, and the second semiconductor layer SEL2 disposed on the first interlayer insulating layer 124.

The circuit layer 120 may further include a first gate insulating layer 122 covering the first semiconductor layer SEL1, a first gate conductive layer GCDL1 disposed on the first gate insulating layer 122, a second gate insulating layer 123 covering the first gate conductive layer GCDL1, a second gate conductive layer GCDL2 disposed between the second gate insulating layer 123 and the first interlayer insulating layer 124, a third gate insulating layer 125 covering the second semiconductor layer SEL2, a third gate conductive layer GCDL3 disposed on the third gate insulating layer 125, a second interlayer insulating layer 126 covering the third gate conductive layer GCDL3, a first source-drain conductive layer SDCDL1 disposed on the second interlayer insulating layer 126, a first planarization layer 127 covering the first source-drain conductive layer SDCDL1, a second source-drain conductive layer SDCDL2 disposed on the first planarization layer 127, and a second planarization layer 128 covering the second source-drain conductive layer SDCDL2.

However, the circuit layer 120 illustrated in FIG. 8 is merely an example, and the circuit layer 120 of the display device 100 is not limited this configuration. For example, the circuit layer 120 may further include one or more additional gate insulating layers disposed on the second gate conductive layer GCDL2 and one or more additional gate conductive layers disposed on the additional gate insulating layers and covered with the first interlayer insulating layer 124.

According to an embodiment, the circuit layer 120 may further include a buffer layer 121 covering the substrate 110. In this embodiment, the first semiconductor layer SEL1 may be disposed on the buffer layer 121.

The circuit layer 120 may include the light-emitting pixel drivers EPD electrically connected to the light emitting elements LE of the element layer 130, respectively.

According to the embodiment of FIG. 7, the circuit layer 120 may include the light-emitting pixel drivers EPD and the power connection transistor TPC electrically connected between two light-emitting pixel drivers EPD neighboring each other in the first direction DR1 among the light-emitting pixel drivers EPD and the first power line VDL.

Each of the light-emitting pixel drivers EPD may include the first transistor T1, the second transistor T2, the third transistor T3, the fourth transistor T4, the fifth transistor T5, the first capacitor C1, and the second capacitor C2.

Each of the first transistor T1, the second transistor T2, the third transistor T3, the fourth transistor T4, the fifth transistor T5, and the power connection transistor TPC may include a gate electrode, a channel overlapping the gate electrode, a first electrode connected to a side of the channel, and a second electrode connected to another side of the channel.

According to an embodiment, the first transistor T1, the second transistor T2, the third transistor T3 and the fourth transistor T4 may be N-type MOSFETs, and the fifth transistor T5 and the power connection transistor TPC may be P-type MOSFETs.

The channels, first electrodes and second electrodes of the P-type MOSFET may be disposed in the first semiconductor layer SEL1, and the channels, first electrodes and second electrodes of the N-type MOSFETs may be disposed in the second semiconductor layer SEL2.

That is, the channel, first electrode and second electrode of each of the first transistor T1, the second transistor T2, the third transistor T3 and the fourth transistor T4 may be disposed in the second semiconductor layer SEL2, and the channel, first electrode and second electrode of each of the fifth transistor T5 and the power connection transistor TPC may be disposed in the first semiconductor layer SEL1.

As illustrated in FIG. 8, the fifth transistor T5 may include a channel CH5 disposed in the first semiconductor layer SEL1, a first electrode E15 disposed in the first semiconductor layer SEL1 and connected to a side of the channel CH5, a second electrode E25 disposed in the first semiconductor layer SEL1 and connected to another side of the channel CH5, and a gate electrode G5 disposed in the first gate conductive layer GCDL1 and overlapping the channel CH5.

The first semiconductor layer SEL1 may include a silicon semiconductor material such as polysilicon or amorphous silicon.

The first semiconductor layer SEL1 may include a first capacitor electrode CAE1.

The first capacitor electrode CAE1 may be electrically connected to a gate electrode G1 of the first transistor T1.

The power connection transistor TPC may be a P-type MOSFET like the fifth transistor T5. Thus, a redundant description thereof is omitted below.

Each of the first transistor T1 and the second transistor T2 may include a channel CH1 or CH2 disposed in the second semiconductor layer SEL2, a first electrode E11 or E12 located in the second semiconductor layer SEL2 and connected to a side of the channel CH1 or CH2, a second electrode E21 or E22 disposed in the second semiconductor layer SEL2 and connected to another side of the channel CH1 or CH2, and a gate electrode G1 or G2 disposed in the third gate conductive layer GCDL3 and overlapping the channel CH1 or CH2.

The second semiconductor layer SEL2 may include an oxide semiconductor material.

The first gate conductive layer GCDL1 may include a second capacitor electrode CAE2 overlapping the first capacitor electrode CAE1.

The second capacitor electrode CAE2 may be electrically connected to the second electrode E21 of the first transistor T1.

Accordingly, the first capacitor C1 may be formed by the first capacitor electrode CAE1 and the second capacitor electrode CAE2 overlapping each other in the third direction DR3 and the first gate insulating layer 122 disposed between the first capacitor electrode CAE1 and the second capacitor electrode CAE2.

The second gate conductive layer GCDL2 may include a third capacitor electrode CAE3 overlapping the second capacitor electrode CAE2.

The third capacitor electrode CAE3 may be electrically connected to the first power line VDL (see FIG. 7).

Accordingly, the second capacitor C2 may be formed by the second capacitor electrode CAE2 and the third capacitor electrode CAE3 overlapping each other in the third direction DR3 and the second gate insulating layer 123 disposed between the second capacitor electrode CAE2 and the third capacitor electrode CAE3.

An upper surface of the channel CH1 of the first transistor T1 may face the gate electrode G1.

In addition, a lower surface of the channel CH1 of the first transistor T1 may face the second capacitor electrode CAE2.

That is, the second capacitor electrode CAE2 may function as a gate additional electrode (e.g., an auxiliary gate electrode) of the first transistor T1.

The first source-drain conductive layer SDCDL1 may include a first node connection electrode NCE1, a second node connection electrode NCE2, a data connection electrode DCE, and a first anode connection electrode ANCE1.

The second source-drain conductive layer SDCDL2 may include a second anode connection electrode ANCE2, the data line DL, and a constant voltage auxiliary line CVAL.

According to an embodiment, one constant voltage auxiliary line CVAL may transmit any one of the first power voltage ELVDD (see FIG. 7), the reference voltage VREF (see FIG. 7), or the first initialization voltage VAINT (see FIG. 7).

The first electrode E12 of the second transistor T2 may be electrically connected to the data line DL through the data connection electrode DCE.

The data connection electrode DCE may be disposed in the first source-drain conductive layer SDCDL1 and may be electrically connected to the first electrode E12 of the second transistor T2 through a first data connection hole DCH1.

The first data connection hole DCH1 may penetrate the second interlayer insulating layer 126 and the third gate insulating layer 125.

The data line DL may be disposed in the second source-drain conductive layer SDCDL2 and may be electrically connected to the data connection electrode DCE through a second data connection hole DCH2 penetrating the first planarization layer 127.

The second electrode E22 of the second transistor T2 may be electrically connected to the gate electrode G1 of the first transistor T1 and the first capacitor electrode CAE1 through the first node connection electrode NCE1.

The first node connection electrode NCE1 may be electrically connected to the gate electrode G1 of the first transistor T1 through a first node connection hole NCH1, electrically connected to the first capacitor electrode CAE1 through a second node connection hole NCH2, and electrically connected to the second electrode E22 of the second transistor T2 through a third node connection hole NCH3.

The second electrode E21 of the first transistor T1 may be electrically connected to the first electrode E15 of the fifth transistor T5 and the second capacitor electrode CAE2 through the second node connection electrode NCE2.

The second node connection electrode NCE2 may be electrically connected to the second electrode E21 of the first transistor T1 through a fourth node connection hole NCH4, electrically connected to the second capacitor electrode CAE2 through a fifth node connection hole NCH5, and electrically connected to the first electrode E15 of the fifth transistor T5 through a sixth node connection hole NCH6.

The second electrode E25 of the fifth transistor T5 may be electrically connected to an anode 131 of the light emitting element LE through the first anode connection electrode ANCE1 and the second anode connection electrode ANCE2.

The first anode connection electrode ANCE1 may be electrically connected to the second electrode E25 of the fifth transistor T5 through a first anode connection hole ANCH1.

The first anode connection hole ANCH1 may penetrate the second interlayer insulating layer 126, the third gate insulating layer 125, the first interlayer insulating layer 124, the second gate insulating layer 123, and the first gate insulating layer 122.

The second anode connection electrode ANCE2 may be electrically connected to the first anode connection electrode ANCE1 through a second anode connection hole ANCH2 penetrating the first planarization layer 127.

The anode 131 may be disposed on the second planarization layer 128 and may be electrically connected to the second anode connection electrode ANCE2 through a third anode connection hole ANCH3.

The element layer 130 may be disposed on the circuit layer 120 and may include the light emitting elements LE corresponding to the emission areas EA, respectively.

Each of the light emitting elements LE may include the anode 131 and a cathode 134 facing each other and a light emitting layer 133 disposed between the anode 131 and the cathode 134.

That is, the element layer 130 may include the anode 131 disposed in each of the emission areas EA, a pixel defining layer 132 disposed in the non-emission area NEA and covering edges of the anode 131, the light emitting layer 133 disposed on the anode 131, and the cathode 134 disposed on the light emitting layer 133 and the pixel defining layer 132.

The pixel defining layer 132 may include a first pixel defining layer 1321 disposed on the second planarization layer 128, a second pixel defining layer 1322 disposed on the first pixel defining layer 1321, and a spacer layer 1323 disposed on a portion of the second pixel defining layer 1322.

For example, the first pixel defining layer 1321 may include a light-absorbing insulating material that absorbs light or a light-blocking insulating material that blocks light.

Alternatively, each of the light emitting elements LE may further include a first common layer disposed between the anode 131 and the light emitting layer 133 and a second common layer disposed between the light emitting layer 133 and the cathode 134.

The anode 131 may be disposed in an emission area EA and may be electrically connected to a light-emitting pixel driver EPD. The anode 131 may be referred to as a pixel electrode.

The light emitting layer 133 may include an organic light emitting material that converts electron-hole pairs into light.

The cathode 134 may be disposed in the display area DA (see FIG. 3) including the emission areas EA. The cathode 134 may be a part of the second power line VSL (see FIG. 7) which transmits the second power voltage ELVSS (see FIG. 7) or may be electrically connected to the second power line VSL. The cathode 134 may be referred to as a common electrode.

The sealing layer 140 may be disposed on the circuit layer 120 and may cover the element layer 130.

For example, the sealing layer 140 may include a first sealing layer disposed on the element layer 130 and including an inorganic insulating material, a second sealing layer disposed on the first sealing layer, overlapping the element layer 130 and including an organic insulating material, and a third sealing layer disposed on the first sealing layer, covering the second sealing layer and including an inorganic insulating material.

FIG. 9 is a layout view illustrating some light-emitting pixel drivers EPD to support the embodiment of FIG. 5.

Referring to FIG. 9, the light-emitting pixel drivers EPD of the circuit layer 120 of the display device 100 according to the embodiment may be arranged in the first direction DR1 and the second direction DR2.

The light-emitting pixel drivers EPD may include a first light-emitting pixel driver EPD1, a second light-emitting pixel driver EPD2, a third light-emitting pixel driver EPD3, a fourth light-emitting pixel driver EPD4, a fifth light-emitting pixel driver EPD5, a sixth light-emitting pixel driver EPD6, a seventh light-emitting pixel driver EPD7, and an eighth light-emitting pixel driver EPD8 arranged side by side with each other in the first direction DR1. For example, the light-emitting pixel drivers EPD1-EPD8 may be arranged in a single row along the first direction DR1.

As illustrated in FIG. 5, the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may be electrically connected to light emitting elements LE (see FIGS. 7 and 8) arranged in eight emission areas EA1 through EA8 neighboring each other in the first direction DR1, the second direction DR2, and the diagonal direction DR5. For example, the first light-emitting pixel driver EPD1 may be electrically connected to a light emitting element LE located in the first emission area EA1, the second light-emitting pixel driver EPD2 may be electrically connected to a light emitting element LE located in the second emission area EA2, and so on through the eighth light-emitting pixel driver EPD8 and the eighth emission area EA8.

As illustrated in FIG. 9, the circuit layer 120 may include lines of the first direction DR1 which transmit different signals or voltages and extend in the first direction DR1.

The lines of the first direction DR1 may include scan write lines GWL, reset control lines GRL, initialization control lines GIL, first emission control lines ECL1, second emission control lines ECL2, reference voltage lines VRL, first power lines VDL, first initialization voltage lines VAIL1, and second initialization voltage lines VAIL2.

According to an embodiment, the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may intersect two scan write lines GWLA and GWLB transmitting different scan write signals GW (see FIG. 7), one reset control line GRL transmitting a reset control signal GR (see FIG. 7), one initialization control line GIL transmitting an initialization control signal GI (see FIG. 7), one first emission control line ECL1 transmitting a first emission control signal EC1 (see FIG. 7), and one second emission control line ECL2 transmitting a second emission control signal EC2 (see FIG. 7).

The two scan write lines GWLA and GWLB, the one reset control line GRL, the one initialization control line GIL, the one first emission control line ECL1, and the one second emission control line ECL2 may each extend in the first direction DR1.

The first light-emitting pixel driver EPD1, the second light-emitting pixel driver EPD2, the third light-emitting pixel driver EPD3, and the fourth light-emitting pixel driver EPD4 may be electrically connected to four light emitting elements LE located in the first emission area EA1, the second emission area EA2, the third emission area EA3, and the fourth emission area EA4, respectively.

In addition, the fifth light-emitting pixel driver EPD5, the sixth light-emitting pixel driver EPD6, the seventh light-emitting pixel driver EPD7, and the eighth light-emitting pixel driver EPD8 may be electrically connected to four light emitting elements LE located in the fifth emission area EA5, the sixth emission area EA6, the seventh emission area EA7, and the eighth emission area EA8 neighboring the first emission area EA1, the second emission area EA2, the third emission area EA3, and the fourth emission area EA4 in the second direction DR2, respectively.

Accordingly, the gate electrode of the second transistor T2 of each of the first light-emitting pixel driver EPD1, the second light-emitting pixel driver EPD2, the third light-emitting pixel driver EPD3, and the fourth light-emitting pixel driver EPD4 may be electrically connected to one GWLA of the two scan write lines GWLA and GWLB.

The gate electrode of the second transistor T2 of each of the fifth light-emitting pixel driver EPD5, the sixth light-emitting pixel driver EPD6, the seventh light-emitting pixel driver EPD7, and the eighth light-emitting pixel driver EPD8 may be electrically connected to the other GWLB of the two scan write lines GWLA and GWLB.

The gate electrode of the third transistor T3 of each of the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may be electrically connected to the one reset control line GRL.

The gate electrode of the fourth transistor T4 of each of the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may be electrically connected to the one initialization control line GIL.

The gate electrodes of four power connection transistors TPC, each electrically connected to two light-emitting pixel drivers neighboring each other in the first direction DR1 among the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7 and the eighth light-emitting pixel driver EPD8, may be electrically connected to the one first emission control line ECL1. For example, one power connection transistor TPC may connect EPD1 and EPD2, another may connect EPD3 and EPD4, another may connect EPD5 and EPD6, and another may connect EPD7 and EPD8, with all four TPCs controlled together by the first emission control line ECL1.

The gate electrode of the fifth transistor T5 of each of the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may be electrically connected to the one second emission control line ECL2.

According to an embodiment, the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may intersect one first power line VDL transmitting the first power voltage ELVDD, one reference voltage line VRL transmitting the reference voltage VREF, and one initialization voltage line VAIL (see FIG. 7) transmitting the initialization voltage VAINT (see FIG. 7).

In this embodiment, the light emitting elements LE respectively disposed in the emission areas EA (see FIG. 5) of the display area DA (see FIGS. 3 and 4) may be initialized to the initialization voltage VAINT of the initialization voltage line VAIL.

The gate electrode of the first transistor T1 of each of the light-emitting pixel drivers EPD (see FIGS. 7 and 8) of the circuit layer 120 may be initialized to the reference voltage VREF.

Alternatively, as illustrated in FIG. 9, according to an embodiment, the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may intersect one first power line VDL transmitting the first power voltage ELVDD, one reference voltage line VRL transmitting the reference voltage VREF, one first initialization voltage line VAIL1 transmitting a first initialization voltage, and one second initialization voltage line VAIL2 transmitting a second initialization voltage different from the first initialization voltage.

The one first power line VDL, the one reference voltage line VRL, the one first initialization voltage line VAIL1, and the one second initialization voltage line VAIL2 may each extend in the first direction DR1.

The first electrode of the third transistor T3 of each of the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may be electrically connected to the one reference voltage line VRL.

According to an embodiment, the light emitting elements LE disposed in the first color emission areas R_EA (see FIG. 5) may be initialized to the first initialization voltage of the first initialization voltage line VAIL1, and the light emitting elements LE disposed in the second color emission areas G_EA (see FIG. 5) and the third color emission areas B_EA (see FIG. 5) may be initialized to the second initialization voltage of the second initialization voltage line VAIL2.

The first emission area EA1 and the seventh emission area EA7 among the eight emission areas EA1 through EA8 may be included in the first color emission areas R_EA.

In this embodiment, the first electrode of the fourth transistor T4 of each of the first light-emitting pixel driver EPD1 and the seventh light-emitting pixel driver EPD7 may be electrically connected to the one first initialization voltage line VAIL1.

The first electrode of the fourth transistor T4 of each of the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, and the eighth light-emitting pixel driver EPD8 may be electrically connected to the one second initialization voltage line VAIL2.

The second capacitors C2 and the first electrodes of the four power connection transistors TPC, each electrically connected to two light-emitting pixel drivers neighboring each other in the first direction DR1 among the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7 and the eighth light-emitting pixel driver EPD8, may be electrically connected to the one first power line VDL. For example, the second capacitor C2 of EPD1 and EPD2 and the first electrode of the power connection transistor TPC that connects EPD1 and EPD2 may be tied to the first power line VDL, and likewise for EPD3 and EPD4, EPD5 and EPD6, and EPD7 and EPD8.

The first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 are arranged only in the first direction DR1, not in the first direction DR1 and the second direction DR2. For example, although the emission areas EA1-EA8 are arranged in both directions, their drivers EPD1-EPD8 are arranged in a single row in the first direction DR.

Accordingly, the lines of the first direction DR1 used to drive the light emitting elements LE (see FIGS. 7 and 8) arranged in the eight emission areas EA1 through EA8 neighboring each other in the first direction DR1, the second direction DR2, and the diagonal direction DR5 need only include one reset control line GRL, one initialization control line GIL, one first emission control line ECL1, and one second emission control line ECL2.

In addition, the lines of the first direction DR1 used to drive the light emitting elements LE (see FIGS. 7 and 8) arranged in the eight emission areas EA1 through EA8 neighboring each other in the first direction DR1, the second direction DR2, and the diagonal direction DR5 may further include one first power line VDL, one reference voltage line VRL, one first initialization voltage line VAIL1, and one second initialization voltage line VAIL2.

Accordingly, the number lines of the first direction DR1 used to drive the light emitting elements LE (see FIGS. 7 and 8) arranged in the eight emission areas EA1 through EA8 neighboring each other in the first direction DR1, the second direction DR2, and the diagonal direction DR5 may be reduced by half, which may enable the display device 100 to achieve a higher resolution.

According to an embodiment, the circuit layer 120 may include data lines DL which extend in the second direction DR2 and transmit data signals Vdata (see FIG. 7).

The data lines DL may be arranged in pairs, with the two data lines DL of each pair arranged adjacent to and/or neighboring each other in the first direction DR1.

One DLA of two data lines DLA and DLB neighboring each other in the first direction DR1 may transmit data signals Vdata for driving the light emitting elements LE disposed in the first color emission areas R_EA (see FIG. 5) and the light emitting elements LE disposed in the third color emission areas B_EA (see FIG. 5).

In addition, the other DLB of the two data lines DLA and DLB neighboring each other in the first direction DR1 may transmit data signals Vdata for driving the light emitting elements LE disposed in the second color emission areas G_EA (see FIG. 5).

As in the example of FIG. 5, the first light-emitting pixel driver EPD1 may be electrically connected to a light emitting element LE disposed in a first color emission area R_EA (see FIG. 5), and the third light-emitting pixel driver EPD3 may be electrically connected to a light emitting element LE disposed in a third color emission area B_EA (see FIG. 5). In addition, each of the second light-emitting pixel driver EPD2 and the fourth light-emitting pixel driver EPD4 may be electrically connected to a light emitting element LE disposed in a second color emission area G_EA (see FIG. 5).

In this embodiment, one DLA of the two data lines DLA and DLB neighboring each other in the first direction DR1 may be electrically connected to the first light-emitting pixel driver EPD1 and the third light-emitting pixel driver EPD3.

One of the first light-emitting pixel driver EPD1 and the third light-emitting pixel driver EPD3 may intersect the one data line DLA.

The other of the first light-emitting pixel driver EPD1 and the third light-emitting pixel driver EPD3 may be electrically connected to the one data line DLA through a first data extension line DEXL1 extending in the first direction DR1.

In addition, the other DLB of the two data lines DLA and DLB neighboring each other in the first direction DR1 may be electrically connected to the second light-emitting pixel driver EPD2 and the fourth light-emitting pixel driver EPD4.

One of the second light-emitting pixel driver EPD2 and the fourth light-emitting pixel driver EPD4 may intersect the other data line DLB.

The other of the second light-emitting pixel driver EPD2 and the fourth light-emitting pixel driver EPD4 may be electrically connected to the other data line DLB through a second data extension line DEXL2 extending in the first direction DR1.

For example, one DLA of the two data lines DLA and DLB neighboring each other in the first direction DR1 may intersect the first light-emitting pixel driver EPD1, and the other data line DLB may intersect the second light-emitting pixel driver EPD2.

In another example, one DLA of the two data lines DLA and DLB neighboring each other in the first direction DR1 may intersect the third light-emitting pixel driver EPD3, and the other data line DLB may intersect the second light-emitting pixel driver EPD2. In this embodiment, the first light-emitting pixel driver EPD1 may be electrically connected to the one data line DLA through the first data extension line DEXL1.

In another example, one DLA of the two data lines DLA and DLB neighboring each other in the first direction DR1 may intersect the third light-emitting pixel driver EPD3, and the other data line DLB may intersect the fourth light-emitting pixel driver EPD4. In this embodiment, the first light-emitting pixel driver EPD1 may be electrically connected to the one data line DLA through the first data extension line DEXL1, and the second light-emitting pixel driver EPD2 may be electrically connected to the other data line DLB through the second data extension line DEXL2.

As in the example of FIG. 5, the fifth light-emitting pixel driver EPD5 may be electrically connected to a light emitting element LE disposed in a third color emission area B_EA (see FIG. 5), and the seventh light-emitting pixel driver EPD7 may be electrically connected to a light emitting element LE disposed in a first color emission area R_EA (see FIG. 5). In addition, each of the sixth light-emitting pixel driver EPD6 and the eighth light-emitting pixel driver EPD8 may be electrically connected to a light emitting element LE located in a second color emission area G_EA (see FIG. 5).

In this embodiment, one DLA of the two data lines DLA and DLB neighboring each other in the first direction DR1 may be electrically connected to the fifth light-emitting pixel driver EPD5 and the seventh light-emitting pixel driver EPD7.

One of the fifth light-emitting pixel driver EPD5 and the seventh light-emitting pixel driver EPD7 may intersect the one data line DLA.

The other of the fifth light-emitting pixel driver EPD5 and the seventh light-emitting pixel driver EPD7 may be electrically connected to the one data line DLA through the first data extension line DEXL1 extending in the first direction DR1.

In addition, the other DLB of the two data lines DLA and DLB neighboring each other in the first direction DR1 may be electrically connected to the sixth light-emitting pixel driver EPD6 and the eighth light-emitting pixel driver EPD8.

One of the sixth light-emitting pixel driver EPD6 and the eighth light-emitting pixel driver EPD8 may intersect the other data line DLB.

The other one of the sixth light-emitting pixel driver EPD6 and the eighth light-emitting pixel driver EPD8 may be electrically connected to the other data line DLB through the second data extension line DEXL2 extending in the first direction DR1.

In this embodiment, even if the eight light-emitting pixel drivers EPD1 through EPD8 electrically connected to the light emitting elements LE (see FIGS. 7 and 8) arranged in the eight emission areas EA1 through EA8 neighboring each other in the first direction DR1, the second direction DR2 and the diagonal direction DR5 are arranged only in the first direction DR1, the number of data lines DL need not be doubled. This configuration may enable the display device 100 to achiever a higher resolution.

FIG. 10 is a plan view of the substrate 110 of FIG. 4 according to an embodiment.

Referring to FIG. 10, the substrate 110 of the display device 100 according to the embodiment includes the main area MA corresponding to the display surface and the sub-area SBA extending from a portion of a side of the main area MA.

The main area MA includes the display area DA and the non-display area NDA located at edges and surrounding the display area DA. The display area DA may substantially occupy a center or central region of the main area DA.

The display area DA may include a bypass area BYA disposed on a side adjacent to the sub-area SBA and a general area GA disposed in an area other than the bypass area BYA. For example, the general area GA may occupy the remaining portion of the display area DA.

The bypass area BYA may include a bypass middle area BMA located in the middle in the first direction DR1, a first bypass side area BSA1 disposed side by side with the bypass middle area BMA in the first direction DR1 and contacting the non-display area NDA, and a second bypass side area BSA2 disposed between the bypass middle area BMA and the first bypass side area BSA1.

The first bypass side area BSA1 may be disposed closer to curved corners of the substrate 110 than the bypass middle area BMA and the second bypass side area BSA2.

The first bypass side area BSA1 and the second bypass side area BSA2 may be disposed between each side of the bypass middle area BMA in the first direction DR1 and the non-display area NDA.

The general area GA may include a general middle area GMA connected to the bypass middle area BMA of the bypass area BYA in the second direction DR2, a first general side area GSA1 connected to the first bypass side area BSA1 of the bypass area BYA in the second direction DR2, and a second general side area GSA2 connected to the second bypass side area BSA2 of the bypass area BYA in the second direction DR2.

The non-display area NDA may include a gate driving circuit area GDRA in which the gate driving circuit GTDR (see FIG. 6) is disposed.

The gate driving circuit area GDRA may face a side of the display area DA extending in the second direction DR2. However, this is merely an example, and the gate driving circuit area GDRA may also be divided and disposed in the display area DA rather than in the non-display area NDA. For example, the gate driving circuit area GDRA may be divided into two portions arranged on opposite sides of the display area DA, instead of being implemented as a single unit in the non-display area NDA.

The gate driving circuit GTDR of the gate driving circuit area GDRA may transmit gate signals to gate lines.

The gate lines may include a scan write line GWL (see FIG. 7), a reset control line GRL (see FIG. 7), an initialization control line GIL (see FIG. 7), a first emission control line ECL1 (see FIG. 7), and a second emission control line ECL2 (see FIG. 7).

The sub-area SBA may include a bending area BA changed into a bent shape, a first sub-area SB1 located between a side of the bending area BA and the main area MA, and a second sub-area SB2 connected to the other side of the bending area BA.

When the bending area BA is changed into the bent shape, the second sub-area SB2 may be placed under the substrate 110 and overlapped by the main area MA.

The display driving circuit 200 may be disposed in the second sub-area SB2.

Signal pads SPD bonded to the circuit board 300 (see FIG. 3) may be arranged at an edge of the second sub-area SB2.

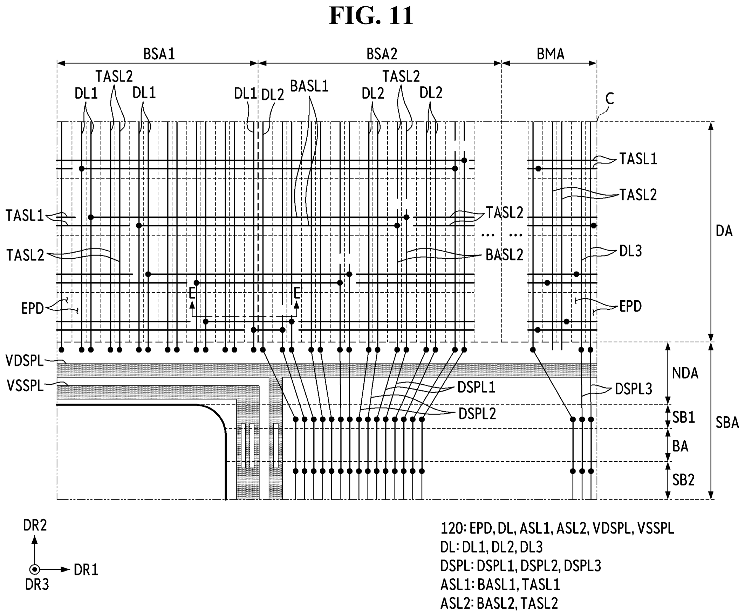

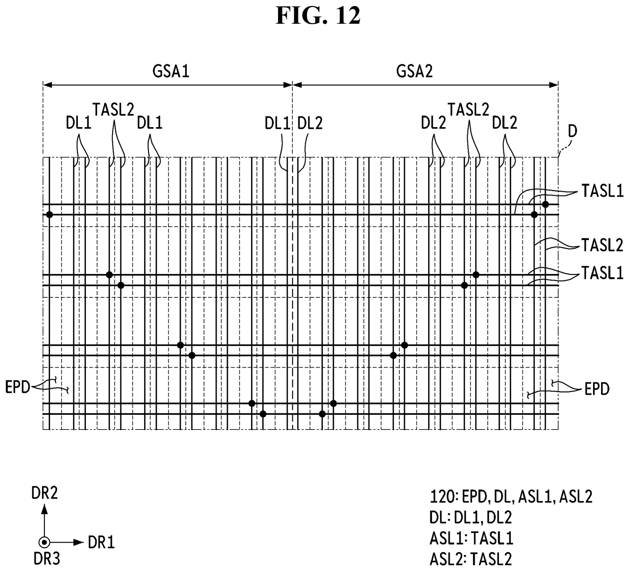

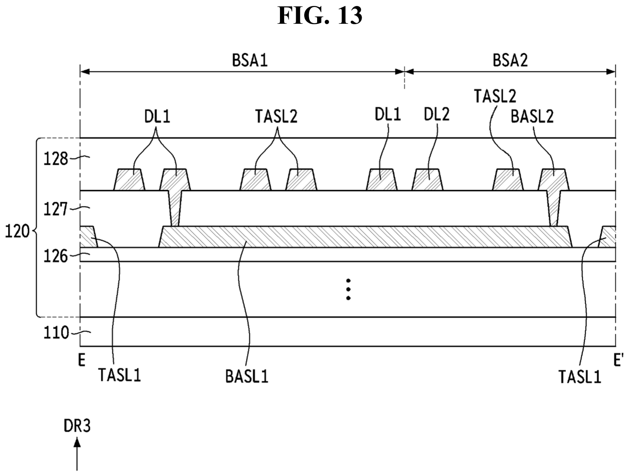

FIG. 11 is a layout view of part C of FIG. 10. FIG. 12 is a layout view of part D of FIG. 10. FIG. 13 is a cross-sectional view taken along line E-E' of FIG. 11.

Referring to FIGS. 11 and 12, the circuit layer 120 of the display device 100 according to the embodiment may include light-emitting pixel drivers EPD arranged side by side with each other in the first direction DR1 and the second direction DR2, data lines DL extending in the second direction DR2 and transmitting data signals Vdata (see FIG. 7) to the light-emitting pixel drivers EPD, first auxiliary lines ASL1 extending in the first direction DR1, and second auxiliary lines ASL2 extending in the second direction DR2.

According to an embodiment, some of the light-emitting pixel drivers EPD may intersect the data lines DL, and the other light-emitting pixel drivers EPD may intersect the second auxiliary lines ASL2. For example, in a case where the number of second auxiliary lines ASL2 is fewer than the number of data lines DL, some of the light-emitting pixel drivers, such as EPD1 through EPD6, may intersect respective data lines DL, while one or more of the remaining pixel drivers, such as EPD7 and EPD8, may intersect second auxiliary lines ASL2.

In this embodiment, since each of the light-emitting pixel drivers EPD do not intersect both a data line DL and a second auxiliary line ASL2, the display device 100 may be able to achieve a higher resolution.

According to an embodiment, the circuit layer 120 may further include data supply lines DSPL disposed in the non-display area NDA and electrically connected between the display driving circuit 200 and the data lines DL.

The data supply lines DSPL may extend to the bypass middle area BMA and the second bypass side area BSA2.

The data supply lines DSPL may include first data supply lines DSPL1 which transmit data signals of first data lines DL1 and second data supply lines DSPL2 which transmit data signals of second data lines DL2.

The data lines DL may include the first data lines DL1 disposed in the first bypass side area BSA1 adjacent to the non-display area NDA in the first direction DR1 and the second data lines DL2 disposed in the second bypass side area BSA2 between the first bypass side area BSA1 and the bypass middle area BMA.

The first auxiliary lines ASL1 may include first bypass auxiliary lines BASL1 electrically connected to the first data lines DL1.

The second auxiliary lines ASL2 may include second bypass auxiliary lines BASL2 electrically connected to the first bypass auxiliary lines BASL1.

The first bypass auxiliary lines BASL1 may electrically connect the first data lines DL1 and the second bypass auxiliary lines BASL2.

The second bypass auxiliary lines BASL2 may electrically connect the first bypass auxiliary lines BASL1 and the first data supply lines DSPL1.

That is, the first data supply lines DSPL1 may extend to the second bypass auxiliary lines BASL2 of the second bypass side area BSA2 and may be electrically connected to the first data lines DL1 through the second bypass auxiliary lines BASL2 and the first bypass auxiliary lines BASL1.

On the other hand, the second data supply lines DSPL2 may extend to the second bypass side area BSA2 and may be directly electrically connected to the second data lines DL2.

When the first data supply lines DSPL1 are extended to the second bypass auxiliary lines BASL2 of the second bypass side area BSA2, rather than to the first data lines DL1 of the first bypass side area BSA1 as described above, the extension length of the first data supply lines DSPL1 may be reduced. Accordingly, a width of an area needed to arrange the data supply lines DSPL may be reduced, thereby reducing a width of the non-display area NDA.

In addition, since the data supply lines DSPL are not disposed in a part of the non-display area NDA which is adjacent to curved corners of the substrate 110, the width of the non-display area NDA can be further reduced.

The data lines DL may further include third data lines DL3 located in the bypass middle area BMA. In addition, the data supply lines DSPL may further include third data supply lines DSPL3 which transmit data signals of the third data lines DL3.

The third data supply lines DSPL3 may extend to the bypass middle area BMA and may be directly electrically connected to the third data lines DL3.

The first auxiliary lines ASL1 may further include first transmission auxiliary lines TASL1 other than the first bypass auxiliary lines BASL1.

The second auxiliary lines ASL2 may further include second transmission auxiliary lines TASL2 other than the second bypass auxiliary lines BASL2.

The first bypass auxiliary lines BASL1 may be disposed between the first data lines DL1 and the second bypass auxiliary lines BASL2.

The second bypass auxiliary lines BASL2 may be disposed between the first data supply lines DSPL1 of the non-display area NDA and the first bypass auxiliary lines BASL1.

When the first bypass auxiliary lines BASL1 and the second bypass auxiliary lines BASL2 are disposed only in the bypass area BYA and ends of the first bypass auxiliary lines BASL1 and ends of the second bypass auxiliary lines BASL2 are disposed in the display area DA, the visibility of the first bypass auxiliary lines BASL1 and the second bypass auxiliary lines BASL2 may be increased.

However, according to an embodiment, the first auxiliary lines ASL1 further include the first transmission auxiliary lines TASL1 in addition to the first bypass auxiliary lines BASL1. In addition, the second auxiliary lines ASL2 further include the second transmission auxiliary lines TASL2 in addition to the second bypass auxiliary lines BASL2.

Accordingly, the visibility of the first bypass auxiliary lines BASL1 and the second bypass auxiliary lines BASL2 can be reduced. For example, by extending connections into the non-display area NDA through the first transmission auxiliary lines TASL1 and the second transmission auxiliary lines TASL2, the portions of the first bypass auxiliary lines BASL1 and the second bypass auxiliary lines BASL2 that remain within the display area DA may be shortened, thereby making them less visible to a viewer.

Two of the first transmission auxiliary lines TASL1 may extend from both ends of a first bypass auxiliary line BASL1 to the non-display area NDA.

One of the second transmission auxiliary lines TASL2 may extend from an end of a second bypass auxiliary line BASL2 to the non-display area NDA in a direction away from the sub-area SBA.

When the second bypass auxiliary lines BASL2 are disposed only in the second bypass side area BSA2, the first data lines DL1 of the first bypass side area BSA1 and the third data lines DL3 of the bypass middle area BMA may entirely neighbor the second transmission auxiliary lines TASL2.

According to an embodiment, each of the first transmission auxiliary lines TASL1 and the second transmission auxiliary lines TASL2 may be electrically connected to one of a first power line VDL (see FIG. 7) that transmits the first power voltage ELVDD (see FIG. 7), a second power line VSL (see FIG. 7) that transmits the second power voltage ELVSS (see FIG. 7), a first initialization voltage line VAIL1 (see FIG. 9) that transmits the first initialization voltage, a second initialization voltage line VAIL2 (see FIG. 9) that transmits the second initialization voltage, and a reference voltage line VRL (see FIG. 7) that transmits the reference voltage VREF (see FIG. 7). In this embodiment, the resistance of a path through which a power voltage (e.g., ELVDD) or a constant voltage (e.g., VREF, VAINT, etc.) is transmitted can be lowered by the first transmission auxiliary lines TASL1 and the second transmission auxiliary lines TASL2. Therefore, the voltage level of the power voltage or constant voltage can be maintained more stably. Accordingly, the display quality of the display device 100 can be enhanced.

According to an embodiment, the circuit layer 120 may further include a first power supply line VDSPL and a second power supply line VSSPL disposed in the non-display area NDA and extending to the sub-area SBA.

The first power supply line VDSPL transmits the first power voltage ELVDD (see FIG. 7), and the second power supply line VSSPL transmits the second power voltage ELVSS (see FIG. 7).

The first power supply line VDSPL may be electrically connected to a first power pad for transmitting the first power voltage ELVDD (see FIG. 7) among the signal pads SPD (see FIG. 9) disposed in the second sub-area SB2.

The second power supply line VSSPL (see FIG. 7) may be electrically connected to a second power pad for transmitting the second power voltage ELVSS (see FIG. 7) among the signal pads SPD (see FIG. 9) disposed in the second sub-area SB2.

For example, at least some of the first transmission auxiliary lines TASL1 may be electrically connected to the second power supply line VSSPL.

In addition, at least some of the second transmission auxiliary lines TASL2 may be electrically connected to at least some of the first transmission auxiliary lines TASL1 and the second power supply line VSSPL.

As illustrated in FIG. 12, the first transmission auxiliary lines TASL1 among the first auxiliary lines ASL1 and the second transmission auxiliary lines TASL2 among the second auxiliary lines ASL2 may be disposed in the general area GA.

Each of the first transmission auxiliary lines TASL1 may be electrically connected to at least some of the second transmission auxiliary lines TASL2.

As illustrated in FIGS. 11 and 12, according to an embodiment, the first auxiliary lines ASL1 may neighbor each other in pairs in the second direction DR2.

Two first auxiliary lines ASL1 neighboring each other in the second direction DR2 among the first auxiliary lines ASL1 may be located adjacent to a boundary between two light-emitting pixel drivers EPD neighboring each other in the second direction DR2.

That is, according to an embodiment, the first auxiliary lines ASL1 are arranged two by two rather than one by one at equal intervals. For example, two adjacent first auxiliary lines ASL1 may be arranged side by side in the second direction DR2 to form a pair, and multiple such pairs may be repeated across the display area DA. Therefore, a width of an area secured for arranging the first auxiliary lines ASL1 can be reduced.

As illustrated in FIG. 13, according to an embodiment, the first auxiliary lines ASL1 may be disposed in the first source-drain conductive layer SDCDL1 (see FIG. 8) on the second interlayer insulating layer 126, and the data lines DL and the second auxiliary lines ASL2 may be disposed in the second source-drain conductive layer SDCDL2 (see FIG. 8) on the first planarization layer 127 which covers the first source-drain conductive layer SDCDL1 (see FIG. 8).

A first bypass auxiliary line BASL1 may be electrically connected to a first data line DL1 through a connection hole and may be electrically connected to a second bypass auxiliary line BASL2 through a connection hole. For example, the connection hole may penetrate the first planarization layer 127.

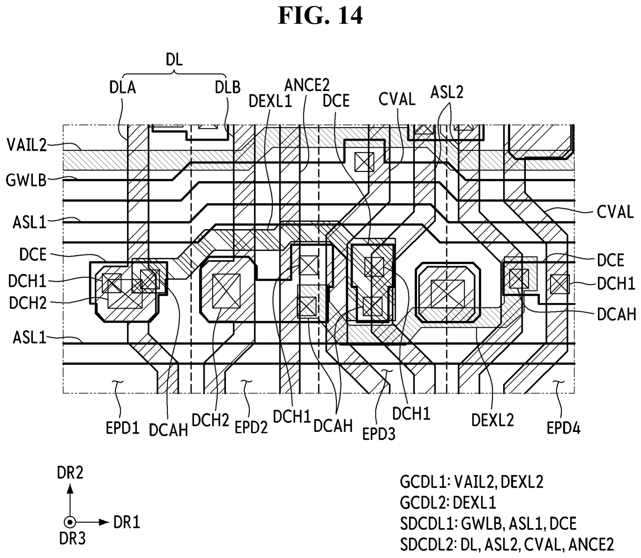

FIGS. 14, 15, 16, 17 and 18 are plan views respectively illustrating different parts of the light-emitting pixel drivers of FIG. 9 according to an embodiment.

As illustrated in FIG. 14, according to an embodiment, one data line DLA of two neighboring data lines DLA and DLB may intersect the first light-emitting pixel driver EPD1, and the other data line DLB may intersect the second light-emitting pixel driver EPD2.

A data connection electrode DCE of the first light-emitting pixel driver EPD1 may overlap a protrusion extending from the one data line DLA and a side of a first data extension line DEXL1 in the third direction DR3.

The data connection electrode DCE of the first light-emitting pixel driver EPD1 may be electrically connected to the one data line DLA through a second data connection hole DCH2 and may be electrically connected to the first electrode of the second transistor T2 (see FIG. 9) through a first data connection hole DCH1.

The data connection electrode DCE of the first light-emitting pixel driver EPD1 may be electrically connected to the first data extension line DEXL1 through a data connection auxiliary hole DCAH.

The first data extension line DEXL1 may extend in the first direction DR1 and may intersect the second light-emitting pixel driver EPD2.

In addition, the other side of the first data extension line DEXL1 may overlap a data connection electrode DCE of the third light-emitting pixel driver EPD3 in the third direction DR3.

The data connection electrode DCE of the third light-emitting pixel driver EPD3 may be electrically connected to the first data extension line DEXL1 through a data connection auxiliary hole DCAH.

Therefore, the first light-emitting pixel driver EPD1 and the third light-emitting pixel driver EPD3 may be electrically connected to the one data line DLA.

A data connection electrode DCE of the second light-emitting pixel driver EPD2 may overlap a protrusion extending from the other data line DLB and a side of a second data extension line DEXL2 in the third direction DR3.

The data connection electrode DCE of the second light-emitting pixel driver EPD2 may be electrically connected to the other data line DLB through a second data connection hole DCH2 and may be electrically connected to the first electrode of the second transistor T2 (see FIG. 9) through a first data connection hole DCH1.

The data connection electrode DCE of the second light-emitting pixel driver EPD2 may be electrically connected to the second data extension line DEXL2 through a data connection auxiliary hole DCAH.

The second data extension line DEXL2 may extend in the first direction DR1 and may intersect the third light-emitting pixel driver EPD3.

In addition, the other side of the second data extension line DEXL2 may overlap a data connection electrode DCE of the fourth light-emitting pixel driver EPD4 in the third direction DR3.

The data connection electrode DCE of the fourth light-emitting pixel driver EPD4 may be electrically connected to the second data extension line DEXL2 through a data connection auxiliary hole DCAH.

Therefore, the second light-emitting pixel driver EPD2 and the fourth light-emitting pixel driver EPD4 may be electrically connected to the other data line DLB.

According to an embodiment, the first gate conductive layer GCDL1 may include a second initialization voltage line VAIL2 and the second data extension line DEXL2.

The second gate conductive layer GCDL2 may include the first data extension line DEXL1.

The first source-drain conductive layer SDCDL1 may include a scan write line GWLB, first auxiliary lines ASL1, and the data connection electrodes DCE.

The second source-drain conductive layer SDCDL2 may include the data lines DL, second auxiliary lines ASL2, constant voltage auxiliary lines CVAL, and a second anode connection electrode ANCE2.

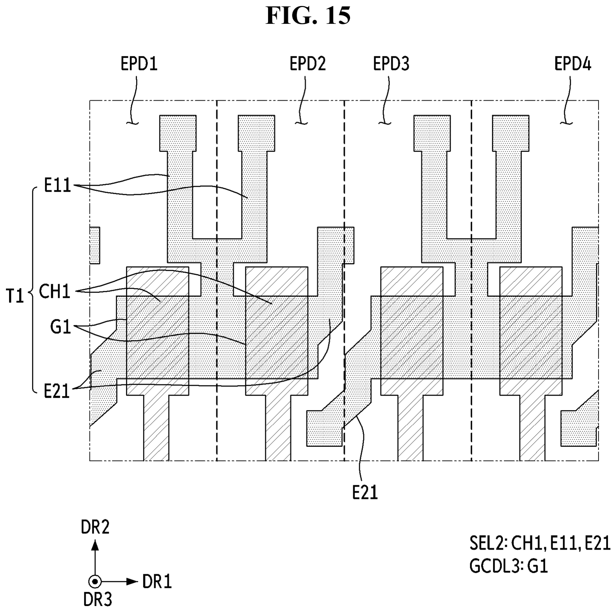

As illustrated in FIG. 15, according to an embodiment, the first transistor T1 may include a channel CH1, a first electrode E11 and a second electrode E21 located in the second semiconductor layer SEL2 and a gate electrode G1 located in the third gate conductive layer GCDL3.

The first electrode E11 and the channel CH1 of the first transistor T1 of the first light-emitting pixel driver EPD1 may be arranged symmetrically to the first electrode E11 and the channel CH1 of the first transistor T1 in the second light-emitting pixel driver EPD2, with respect to a boundary between the first light-emitting pixel driver EPD1 and the second light-emitting pixel driver EPD2.

According to an embodiment, the first electrode E11 of the first transistor T1 of the first light-emitting pixel driver EPD1 and the first electrode E11 of the first transistor T1 of the second light-emitting pixel driver EPD2 may be connected to each other.

According to an embodiment, the second electrode E21 of the first transistor T1 of the second light-emitting pixel driver EPD2 may extend to one side (an upper side of FIG. 15) in the second direction DR2, and the second electrode E21 of the first transistor T1 of the third light-emitting pixel driver EPD3 may extend to the other side (a lower side of FIG. 15) in the second direction DR2.

For example, the second electrode E21 of the first transistor T1 in the second light-emitting pixel driver EPD2 may be point-symmetrical to the second electrode E21 of the first transistor T1 in the third light-emitting pixel driver EPD3.

Accordingly, a size of each light-emitting pixel driver EPD can be decreased, which may enable the display device 100 to achieve a higher resolution.

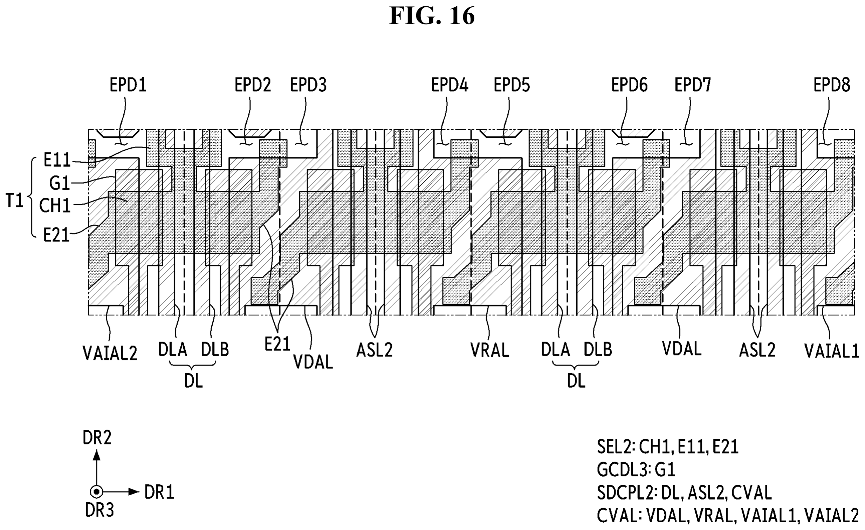

A first transistor T1, data lines DL, and second auxiliary lines ASL2 according to an embodiment of FIG. 16 are substantially the same as or similar to those of the embodiment of FIG. 14 or the embodiment of FIG. 15, and thus a redundant description thereof is omitted below.

As illustrated in FIG. 16, according to an embodiment, the circuit layer 120 may include constant voltage auxiliary lines CVAL, which extend in the second direction DR2 and transmit constant voltages.

The second source-drain conductive layer SDCDL2 may include the data lines DL, the second auxiliary lines ASL2, and the constant voltage auxiliary lines CVAL.

Each of the constant voltage auxiliary lines CVAL may be disposed between two data lines DL and two second auxiliary lines ASL2 in the first direction DR1.

The constant voltage auxiliary lines CVAL may include first power auxiliary lines VDAL that transmit the first power voltage ELVDD, a reference voltage auxiliary line VRAL that transmits the reference voltage VREF, a first initialization voltage auxiliary line VAIAL1 that transmits the first initialization voltage, and a second initialization voltage auxiliary line VAIAL2 that transmits the second initialization voltage.

The first power auxiliary lines VDAL may be alternately arranged in the first direction DR1 with the reference voltage auxiliary line VRAL, the first initialization voltage auxiliary line VAIAL1 transmitting the first initialization voltage, and the second initialization voltage auxiliary line VAIAL2 transmitting the second initialization voltage.

According to an embodiment, a second electrode E21 of the first transistor T1 of each of the first light-emitting pixel driver EPD1, the second light-emitting pixel driver EPD2, the third light-emitting pixel driver EPD3, the fourth light-emitting pixel driver EPD4, the fifth light-emitting pixel driver EPD5, the sixth light-emitting pixel driver EPD6, the seventh light-emitting pixel driver EPD7, and the eighth light-emitting pixel driver EPD8 may overlap one of the constant voltage auxiliary lines CVAL.

In this embodiment, the output of the first transistor T1 is protected from being coupled to a data signal Vdata of a data line DL by the constant voltage auxiliary line CVAL and thus can be maintained relatively stably. Therefore, the display quality of the display device 100 can be enhanced.

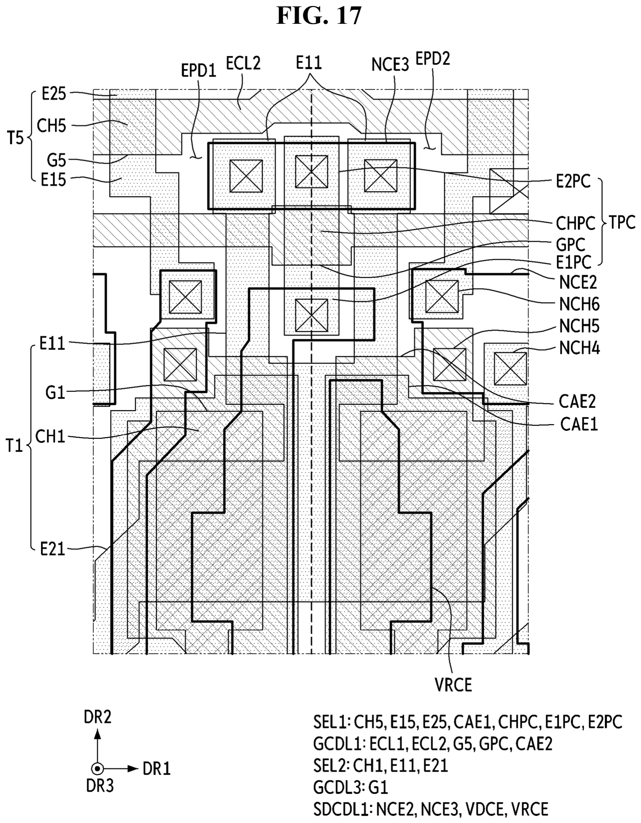

A first transistor T1 according to an embodiment of FIG. 17 is substantially the same as or similar to the first transistor T1 according to the embodiment of FIG. 15, and thus a redundant description thereof is omitted below.

As illustrated in FIG. 17, according to an embodiment, the circuit layer 120 may include a first power line VDL (see FIG. 9) that transmits the first power and a power connection transistor TPC that is electrically connected between two light-emitting pixel drivers EPD1 and EPD2 neighboring each other in the first direction DR1.

The power connection transistor TPC may include a channel CHPC, a first electrode E1PC and a second electrode E2PC disposed in the first semiconductor layer SEL1 and a gate electrode GPC disposed in the first gate conductive layer GCDL1.

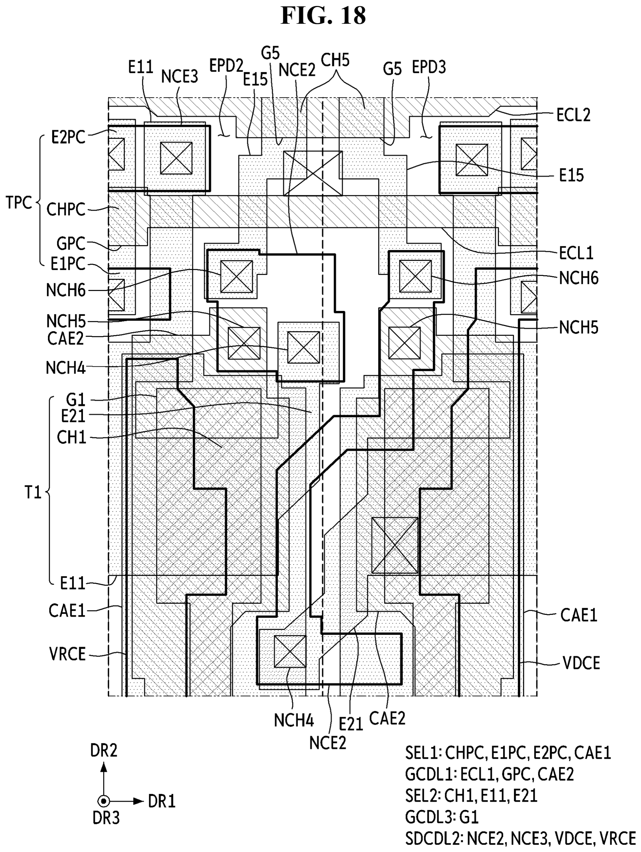

The first electrode E1PC of the power connection transistor TPC may be electrically connected to the first power line VDL through a power connection electrode VDCE (e.g., see FIG. 18).

The power connection electrode VDCE may be located in the first source-drain conductive layer SDCDL1.

The light-emitting pixel drivers EPD of the circuit layer 120 may include the first light-emitting pixel driver EPD1 and the second light-emitting pixel driver EPD2 neighboring each other in the first direction DR1.

The second electrode E2PC of the power connection transistor TPC may be electrically connected to a first electrode E11 of the first transistor T1 of the first light-emitting pixel driver EPD1 and a first electrode E11 of the first transistor T1 of the second light-emitting pixel driver EPD2 through a third node connection electrode NCE3.

The third node connection electrode NCE3 may be disposed in the first source-drain conductive layer SDCDL1.

The gate electrode GPC of the power connection transistor TPC may be a portion of a first emission control line ECL1 which overlaps the channel CHPC of the power connection transistor TPC in the third direction DR3.

The first emission control line ECL1 may be disposed in the first gate conductive layer GCDL1.

Each of the first light-emitting pixel driver EPD1 and the second light-emitting pixel driver EPD2 may include a fifth transistor T5 electrically connected between a second electrode E21 of the first transistor T1 and a second node N2 (see FIG. 9).

The fifth transistor T5 may include a channel CH5, a first electrode E15, and a second electrode E25 located in the first semiconductor layer SEL1 and a gate electrode G5 located in the first gate conductive layer GCDL1.

The first electrode E15 of the fifth transistor T5 may be electrically connected to the second electrode E21 of the first transistor T1 through a second node connection electrode NCE2.

The second electrode E25 of the fifth transistor T5 may be electrically connected to a first anode connection electrode ANCE1 (see FIG. 8).

The gate electrode G5 of the fifth transistor T5 may be a portion of a second emission control line ECL2 which overlaps the channel CH5 of the fifth transistor T5 in the third direction DR3.

The second emission control line ECL2 may be disposed in the first gate conductive layer GCDL1.

The second node connection electrode NCE2 may be disposed in the first source-drain conductive layer SDCDL1.

The second node connection electrode NCE2 may be electrically connected to the second electrode E21 of the first transistor T1 through a fourth node connection hole NCH4, may be electrically connected to a second capacitor electrode CAE2 through a fifth node connection hole NCH5, and may be electrically connected to the first electrode E15 of the fifth transistor T5 through a sixth node connection hole NCH6.

The second capacitor electrode CAE2 may be disposed in the first gate conductive layer GCDL1 and may overlap a first capacitor electrode CAE1 in the third direction DR3.

The first capacitor electrode CAE1 may be disposed in the first semiconductor layer SEL1.

The first source-drain conductive layer SDCDL1 may further include a reference voltage connection electrode VRCE.

A portion of the reference voltage connection electrode VRCE may be arranged symmetrically to a portion of the power connection electrode VDCE with respect to the boundary between the first light-emitting pixel driver EPD1 and the second light-emitting pixel driver EPD2.

A power connection transistor TPC, a first transistor T1, a fifth transistor T5, a first capacitor electrode CAE1, a second capacitor electrode CAE2, a second node connection electrode NCE2, and a third node connection electrode NCE3 according to an embodiment of FIG. 18 are substantially the same as or similar to those of the embodiment of FIG. 17, and thus a redundant description thereof is omitted below.

As illustrated in FIG. 15, according to an embodiment, a second electrode E21 of the first transistor T1 of the second light-emitting pixel driver EPD2 may extend to one side (the upper side of FIG. 15) in the second direction DR2, and a second electrode E21 of the first transistor T1 of the third light-emitting pixel driver EPD3 may extend to the other side (the lower side of FIG. 15) in the second direction DR2.

As illustrated in FIG. 18, a second emission control line ECL2 intersecting the second light-emitting pixel driver EPD2 and the third light-emitting pixel driver EPD3 may be disposed on one side (an upper side of FIG. 18) of the first transistor T1 of each of the second light-emitting pixel driver EPD2 and the third light-emitting pixel driver EPD3 in the second direction DR2.

In this embodiment, the second electrode E21 of the first transistor T1 of the second light-emitting pixel driver EPD2 extends to one side (the upper side of FIG. 18) in the second direction DR2. Therefore, a portion of the second electrode E21 of the first transistor T1 of the second light-emitting pixel driver EPD2 may be located adjacent to a first electrode E15 of the fifth transistor T5.

On the other hand, the second electrode E21 of the first transistor T1 of the third light-emitting pixel driver EPD3 extends to the other side (the lower side of FIG. 18) in the second direction DR2. Therefore, the second electrode E21 of the first transistor T1 of the third light-emitting pixel driver EPD3 may be spaced relatively far from a first electrode E15 of the fifth transistor T5 of the third light-emitting pixel driver EPD3.

According to an embodiment, the second electrode E21 of the first transistor T1 of the third light-emitting pixel driver EPD3 may be electrically connected to the first electrode E15 of the fifth transistor T5 of the third light-emitting pixel driver EPD3 through a second node connection electrode NCE2 extending in the second direction DR2.

For ease of description, the second node connection electrode NCE2 extending in the second direction DR2 may be referred to as a node connection electrode below.

In other words, a second node connection electrode NCE2 of the second light-emitting pixel driver EPD2 may not extend in a particular direction, whereas the second node connection electrode NCE2 of the third light-emitting pixel driver EPD3 may extend toward one side (the upper side of FIG. 18) in the second direction DR2.

Referring back to FIG. 5 and FIG. 9, in another embodiment, the display area DA includes two sets or groups of emission areas, each set or group having four emission areas configured to provide two green color emission areas G_EA, one blue color emission area B_EA, and one red color emission area R_EA. For example, the first set or group may include EA1 (R), EA2 (G), EA3 (B), and EA4 (G), and the second set or group may include EA5 (B), EA6 (G), EA7 (R), and EA8 (G). The first set or group may be controlled by light-emitting pixel drivers EPD1-4 arranged in a row along the first direction DR1. The second set or group may be controlled by light-emitting pixel drivers EPD5-EPD8. In some embodiments, only the first set or group is implemented (e.g., EA1-EA4 driven by EPD1-EPD4), and the second set or group is omitted, thereby simplifying the pixel structure while still providing a balanced distribution of red, green, and blue emission areas.

The display device 100 of each embodiment described above can be applied to various electronic apparatuses.

An electronic apparatus 10 according to an embodiment may include the display device 100 described above.

In addition, the electronic apparatus 10 according to the embodiment may further include modules or devices having other additional functions, in addition to the display device 100.

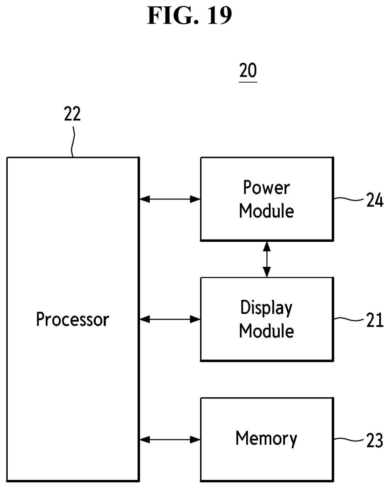

FIG. 19 is a block diagram of an electronic apparatus 10 according to an embodiment.

Referring to FIG. 19, the electronic apparatus 10 according to the embodiment may include a display module 21, a processor 22, a memory 23, and a power module 24.

The display module 21 may include a display device 100 which displays an image.

The processor 22 may include at least one of a central processing unit (CPU), an application processor (AP), a graphic processing unit (GPU), a communication processor (CP), an image signal processor (ISP), and a controller.

The memory 23 may store data information necessary for the operation of the processor 22 or the display module 21. When the processor 22 executes an application stored in the memory 23, an image data signal and/or an input control signal may be transmitted to the display module 21, and the display module 21 may process the received signal and output image information through a display screen.

The power module 24 may include a power supply module, such as a power adapter or a battery device, and a power conversion module. The power conversion module may generate power necessary for the operation of the electronic apparatus 10 by converting power supplied by the power supply module.

At least one of the elements of the electronic apparatus 10 described above may be included in the display device 100 according to the above-described embodiments. In addition, some of individual modules functionally included in one module may be included in the display device 100, and other modules may be provided separately from the display device 100. For example, the display device 100 may include the display module 21, and the processor 22, the memory 23 and the power module 24 may be provided not in the display device 100 but in the form of other devices within the electronic apparatus 10.

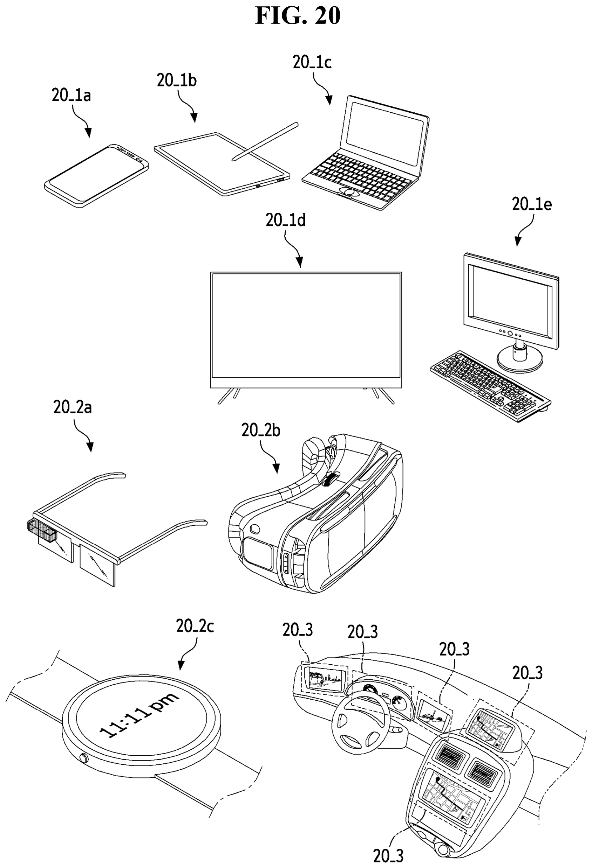

FIG. 20 is a schematic diagram of electronic apparatuses according to various embodiments.

Referring to FIG. 20, electronic apparatuses 10 according to embodiments may include image display electronic apparatuses such as a smartphone 10_1a, a tablet PC 10_1b, a laptop 10_1c, a television 10_1d, and a desk monitor 10_1e. In addition, the electronic apparatuses 10 according to the embodiments may include wearable electronic apparatuses such as smart glasses 10_2a, a head-mounted display 10_2b and a smart watch 10_2c and vehicle electronic apparatuses 10_3 such as a center information display (CID) and a room mirror display placed on an instrument cluster, center fascia and dashboard of a vehicle.

However, the effects of the present invention are not limited to the embodiments described above. Additional variations and modifications will be apparent to those skilled in the art from consideration of the present description.

## Claims

1. A display device (100) comprising:
a display panel comprising:
a display area (DA) in which emission areas (EA) are arranged;
a circuit layer (120); and
light emitting elements (LE) disposed in the emission areas (EA) on the circuit layer (120), the emission areas (EA) being arranged in a first direction (DR1) and a second direction (DR2),
wherein the circuit layer (120) comprises light-emitting pixel drivers (EPD) arranged side by side in the first direction (DR1) in the display area (DA) and electrically connected to the light emitting elements (LE), and
wherein a group of the light emitting elements (LE), each disposed in a corresponding one of the emission areas (EA) neighboring each other in the first direction (DR1), the second direction (DR2) and a diagonal direction (DR4, DR5) intersecting the first direction (DR1) and the second direction (DR2) are electrically connected to a corresponding one of the corresponding light-emitting pixel drivers (EPD) arranged side by side in the first direction (DR1).

2. The display device (100) of claim 1, wherein
eight of the light emitting elements (LE), disposed in eight of the emission areas (EA1-EA8) neighboring each other in the first direction (DR1), the second direction (DR2) and the diagonal direction (DR4, DR5) intersecting the first direction (DR1) and the second direction (DR2) are electrically connected to eight of the light-emitting pixel drivers (EPD1-EPD8) arranged side by side in the first direction (DR1).

3. The display device (100) of claim 1 or 2, wherein:
the circuit layer (120) further comprises:
a first power line (VDL) configured to transmit a first power voltage; and
a power connection transistor (TPC) electrically connected between two of the light-emitting pixel drivers (EPD) neighboring each other in the first direction (DR1) and the first power line (VDL), and
each of the light-emitting pixel drivers (EPD) comprises:
a first transistor (T1) electrically connected between the power connection transistor (TPC) and a first node (N1),
wherein the first transistor (T1) configured to generate a driving current, a first electrode (E11) of the first transistor (T1) is electrically connected to the power connection transistor (TPC), and the first node (N1) is electrically connected to a second electrode (E21) of the first transistor (T1).

4. The display device (100) of claim 3, wherein the circuit layer (120) further comprises:
a first semiconductor layer (SEL1);
a first interlayer insulating layer (124) disposed on the first semiconductor layer (SEL1); and
a second semiconductor layer (SEL2) disposed on the first interlayer insulating layer (124) and comprising an oxide semiconductor material,
wherein a channel (CH1), the first electrode (E11) and the second electrode (E21) of the first transistor (T1) are disposed in the second semiconductor layer (SEL2), and a channel (CHPC), a first electrode (E1PC) and a second electrode (E2PC) of the power connection transistor (TPC) are disposed in the first semiconductor layer (SEL1).

5. The display device (100) of at least one of claims 2 to 4, wherein:
the eight emission areas (EA1-EA8) comprise:
a first emission area (EA1);
a second emission area (EA2) neighboring the first emission area (EA1) in the diagonal direction (DR5);
a third emission area (EA3) neighboring the first emission area (EA1) in the first direction (DR1);
a fourth emission area (EA4) neighboring the third emission area (EA3) in the diagonal direction (DR5) and neighboring the second emission area (EA2) in the first direction (DR1);
a fifth emission area (EA5) neighboring the first emission area (EA1) in the second direction (DR2);
a sixth emission area (EA6) neighboring the fifth emission area (EA5) in the diagonal direction (DR5) and neighboring the second emission area (EA7) in the second direction (DR2);
a seventh emission area (EA7) neighboring the fifth emission area (EA5) in the first direction (DR1) and neighboring the third emission area (EA3) in the second direction (DR2); and
an eighth emission area (EA8) neighboring the seventh emission area (EA7) in the diagonal direction (DR5), neighboring the sixth emission area (EA6) in the first direction (DR1) and neighboring the fourth emission area (EA4) in the second direction (DR2), and the eight light-emitting pixel drivers (EPD1-EPD8) comprise:
a first light-emitting pixel driver (EPD1) electrically connected to a light emitting element (LE) of the first emission area (EA1);
a second light-emitting pixel driver (EPD2) electrically connected to a light emitting element (LE) of the second emission area (EA2);
a third light-emitting pixel driver (EPD3) electrically connected to a light emitting element (LE) of the third emission area (EA3);
a fourth light-emitting pixel driver (EPD4) electrically connected to a light emitting element (LE) of the fourth emission area (EA4);
a fifth light-emitting pixel driver (EPD5) electrically connected to a light emitting element (LE) of the fifth emission area (EA5);
a sixth light-emitting pixel driver (EPD6) electrically connected to a light emitting element (LE) of the sixth emission area (EA6);
a seventh light-emitting pixel driver (EPD7) electrically connected to a light emitting element (LE) of the seventh emission area (EA7); and
an eighth light-emitting pixel driver (EPD8) electrically connected to a light emitting element (LE) of the eighth emission area (EA8).

6. The display device (100) of claim 5, wherein:
each of the first emission area (EA1) and the seventh emission area (EA7) are configured to emit light of a first wavelength band;
each of the second emission area (EA2), the fourth emission area (EA4), the sixth emission area (EA6) and the eighth emission area (EA8) are configured to emit light of a second wavelength band lower than the first wavelength band; and
each of the third emission area (EA3) and the fifth emission area (EA5) are configured to emit light of a third wavelength band lower than the second wavelength band.

7. The display device (100) of claim 3 and claim 5 or 6, wherein:
the first electrode (E11) and a channel (CH1) of the first transistor (T1) of the first light-emitting pixel driver (EPD1) are arranged symmetrically to the first electrode (E11) and the channel (CH1) of the first transistor (T1) of the second light-emitting pixel driver (EPD2) with respect to a boundary between the first light-emitting pixel driver (EPD1) and the second light-emitting pixel driver (EPD2); and
the first electrode (E11) of the first transistor (T1) of the first light-emitting pixel driver (EPD1) is connected to the first electrode (E11) of the first transistor (T1) of the second light-emitting pixel driver (EPD2).

8. The display device (100) of at least one of claims 3 to 7, wherein each of the light-emitting pixel drivers (EPD) further comprises:
a second transistor (T5) electrically connected between the first node (N1) and a second node (N2); and
a node connection electrode (NCE2) electrically connecting the second electrode (E21) of the first transistor (T1) and a first electrode (E15) of the second transistor (T5),
wherein the second electrode (E21) of the first transistor (T1) of the second light-emitting pixel driver (EPD2) extends to one side in the second direction (DR2), the second electrode (E21) of the first transistor (T1) of the third light-emitting pixel driver (EPD3) extends to the other side in the second direction (DR2), and
wherein the node connection electrode (NCE2) of the third light-emitting pixel driver (EPD3) extends in the second direction (DR2).

9. The display device (100) of at least one of claims 3 to 7, wherein each of the light-emitting pixel drivers (EPD) further comprises:
a second transistor (T2) electrically connected between a data line (DL), which transmits a data signal, and a gate electrode (G1) of the first transistor (T1);
a third transistor (T3) electrically connected between a reference voltage line (VRL), which transmits a reference voltage, and the gate electrode (G1) of the first transistor (T1);
a fourth transistor (T4) electrically connected between an initialization voltage line (VAIL), which transmits an initialization voltage, and a second node (N2);
a fifth transistor (T5) electrically connected between the first node (N1) and the second node (N2);
a first capacitor (C1) electrically connected between the gate electrode (G1) of the first transistor (T1) and the first node (N1); and
a second capacitor (C2) electrically connected between the first node (N1) and the first power line (VDL),
wherein the second node (N2) is electrically connected to one of the light emitting elements (LE), and wherein the first electrode (E11) of the first transistor (T1) especially is electrically connected to the power connection transistor (TPC).

10. The display device (100) of claims 2 and 9, wherein:
each of the first through eighth light-emitting pixel drivers (EPD1-EPD8) intersect two scan write lines (GWLA, GWLB) transmitting different scan write signals, one reset control line (GRL) transmitting a reset control signal, one initialization control line (GIL) transmitting an initialization control signal, one first emission control line (ECL1) transmitting a first emission control signal and one second emission control line (ECL2) transmitting a second emission control signal,
wherein a gate electrode (G2) of the second transistor (T2) of each of the first through fourth light-emitting pixel drivers (EPD1-EPD4) is electrically connected to one of the two scan write lines (GWLA, GWLB),
wherein a gate electrode (G2) of the second transistor (T2) of each of the fifth through eighth light-emitting pixel drivers (EPD5-EPD8) is electrically connected to the other of the two scan write lines (GWLA, GWLB),
wherein a gate electrode (G3) of the third transistor (T3) of each of the first through eighth light-emitting pixel drivers (EPD1-EPD8) is electrically connected to the one reset control line (GRL),
wherein a gate electrode of the fourth transistor (T4) of each of the first through eighth light-emitting pixel drivers (EPD1-EPD8) is electrically connected to the one initialization control line (GIL),
wherein gate electrodes (GPC) of four power connection transistors (TPC) electrically connected to the first through eighth light-emitting pixel drivers (EPD1-EPD8) are electrically connected to the one first emission control line (ECL1), and
wherein a gate electrode (G5) of the fifth transistor (T5) of each of the first to eighth light-emitting pixel drivers (EPD1-EPD8) is electrically connected to the one second emission control line (ECL2).

11. The display device (100) of claims 2 and 9, wherein:
one of the first light-emitting pixel driver (EPD1) and the third light-emitting pixel driver (EPD3) intersects a first data line (DL1) and is electrically connected to the first data line (DL1), the other of the first light-emitting pixel driver (EPD1) and the third light-emitting pixel driver (EPD3) is electrically connected to the first data line (DL1) through a first data extension line (DEXL1) extending in the first direction (DR1), and
one of the second light-emitting pixel driver (EPD2) and the fourth light-emitting pixel driver (EPD4) intersects a second data line (DL2) and is electrically connected to the second data line (DL2), and the other of the second light-emitting pixel driver (EPD2) and the fourth light-emitting pixel driver (EPD4) is electrically connected to the second data line (DL2) through a second data extension line extending (DEXL2) in the first direction (DR1).

12. The display device (100) of claim 11, wherein:
the circuit layer (120) further comprises constant voltage auxiliary lines (CVAL) extending in the second direction (DR2) and transmitting constant voltages,
the first through eighth light-emitting pixel drivers (EPD1-EPD8) intersect a first initialization voltage line (VAIL1) extending in the first direction (DR1) and transmitting a first initialization voltage and a second initialization voltage line (VAIL2) extending in the first direction (DR1) and transmitting a second initialization voltage different from the first initialization voltage,
the first initialization voltage line (VAIL1) is electrically connected to first electrodes of the fourth transistors (T4) of some of the first though eighth light-emitting pixel drivers (EPD1-EPD8), the second initialization voltage line (VAIL2) is electrically connected to first electrodes of the fourth transistors (T4) of a remainder of the first through eighth light-emitting pixel drivers (EPD1-EPD8), and
the constant voltage auxiliary lines (CVAL) comprise:
a first power auxiliary line (VDAL) transmitting the first power voltage;
a reference voltage auxiliary (VRAL) line transmitting the reference voltage;
a first initialization voltage auxiliary line (VAIAL1) transmitting the first initialization voltage; and
a second initialization voltage auxiliary line (VAIAL2) transmitting the second initialization voltage,
wherein the second electrode (E21) of the first transistor (T1) of each of the first through eighth light-emitting pixel drivers (EPD1-EPD8) overlaps one of the constant voltage auxiliary lines (CVAL) in a third direction (DR3).

13. The display device (100) of at least one of claims 5 to 12, wherein the circuit layer (120) further comprises:
data lines (DL) extending in the second direction (DR2) and transmitting data signals;
first auxiliary lines (ASL1) extending in the first direction (DR1); and
second auxiliary lines (ASL2) extending in the second direction (DR2),
wherein two neighboring data lines (DL) among the data lines (DL) intersect the first light-emitting pixel driver (EPD1) and the second light-emitting pixel driver (EPD2), respectively, and two neighboring second auxiliary lines (ASL2) among the second auxiliary lines (ASL2) intersect the third light-emitting pixel driver (EPD3) and the fourth light-emitting pixel driver (EPD4), respectively.

14. The display device (100) of claim 13, further comprising:
a display driving circuit (200) supplying the data signals to the data lines (DL),
wherein the display panel further comprises a non-display area (NDA) disposed adjacent the display area (DA) and the circuit layer (120) further comprises data supply lines (DSPL) disposed in the non-display area (NDA) and electrically connected between the data lines (DL) and the display driving circuit (200); and
wherein the display area (DA) further comprises:
a bypass middle area (DSPA);
a first bypass side area (BSA1) disposed side by side with the bypass middle area (DSPA) in the first direction (DR1) and contacting the non-display area (NDA); and
a second bypass side area (BSA2) disposed between the bypass middle area (DSPA) and the first bypass side area (BSA1),
wherein the data supply lines (DSPL) extend to the bypass middle area (DSPA) and the second bypass side area (BSA2),
wherein the data lines (DL) comprise a first data line (DL1) disposed in the first bypass side area (BSA1) and a second data line (DL2) disposed in the second bypass side area (BSA2),
wherein the first auxiliary lines (ASL1) comprise a first bypass auxiliary line (BSASL1) electrically connected to the first data line (DL1),
wherein the second auxiliary lines (ASL2) comprise a second bypass auxiliary line (BSASL2) electrically connected to the first bypass auxiliary line (BSASL1) and neighboring the second data line (DL2),
wherein a first data supply line (DSPL1) transmitting a data signal of the first data line (DL1) among the data supply lines (DSPL) is electrically connected to the first data line (DL1) through the first bypass auxiliary line (BSASL1) and the second bypass auxiliary line (BSASL2), and
wherein a second data supply line (DSPL2) transmitting a data signal of the second data line (DL2) among the data supply lines (DSPL) is directly electrically connected to the second data line (DL2).

15. The display device (100) of at least one of claims 1 to 14, wherein:
the circuit layer (120) further comprises:
a first power line (VDL) configured to transmit a first power voltage; and
a power connection transistor (TPC) electrically connected between two of the light-emitting pixel drivers (EPD) neighboring each other in the first direction (DR1), and
each of the light-emitting pixel drivers (EPD) comprises:
a first transistor (T1) electrically connected between the power connection transistor (TPC) and a first node (N1) and generating a driving current,
wherein the first node (N1) is electrically connected to a second electrode (E21) of the first transistor (T1),
wherein a first electrode (E1PC) of the power connection transistor (TPC) is electrically connected to the first power line (VDL),
wherein a first electrode (E11) and a channel (CH1) of the first transistor (T1) of a first one of the light-emitting pixel drivers (EPD) are arranged symmetrically to a first electrode (E11) and a channel (CH1) of the first transistor (T1) of a second one of the light-emitting pixel drivers (EPD) with respect to a boundary between the first one of the light-emitting pixel drivers (EPD) and the second one of the light-emitting pixel drivers (EPD), and
wherein the first electrode (E11) of the first transistor (T1) of the first one of the light-emitting pixel drivers (EPD) and the first electrode (E11) of the first transistor (T1) of the second one of the light-emitting pixel drivers (EPD) are connected to each other and are electrically connected to a second electrode (E2PC) of the power connection transistor (TPC).

16. An electronic device (10) comprising:
a display device (100) according to at least one of claims 1 to 15 configured to display an image;
a memory (23) configured to store an application;
a processor (22) configured to transmit an image data signal and an input control signal to the display device (100) by executing the application; and
a power module (24) configured to supply power to the display device (100).
